# EUROPEAN PATENT APPLICATION

(11) **EP 4 635 788 A1**
(43) Date of publication of application: **22.10.2025**
(21) Application number: 24170768.6
(22) Date of filing: 17.04.2024
(51) Int. Cl.: B60L 55/00, G01R 31/387, B60L 58/10, B60L 58/12, B60L 58/22

(54) **MEASURING BATTERY CAPACITY OF A BATTERY INSTALLED ON A VEHICLE THROUGH VEHICLE-TO-GRID (V2G) DISCHARGE AND CHARGE CYCLING OPERATION**

(71) Applicant: VOLVO TRUCK CORPORATION, 405 08 Göteborg (SE)
(72) Inventor: BRUNET, Simon, 438 33 LANDVETTER (SE); HJELLE, Tommy, 423 53 TORSLANDA (SE)
(74) Representative: Kransell & Wennborg KB

(57) **Abstract**

Aspects disclosed herein involve measuring battery capacity of a battery installed on a vehicle through a vehicle-to-grid (V2G) discharge and charge cycling operation. The EV is configured to perform the discharge / charge cycle in the discharge/charge operational mode cooperatively through a power connection to a charging station configured to operate in a V2G mode to determine battery capacity. The charging station is not only controllable by the EV to charge its battery from grid power, but the charging station is also controllable by the EV to discharge energy from its battery back to the grid in a V2G operation. The EV can disable onboard, non-essential power consuming devices before starting the discharge cycle so that measured discharge energy can be controlled to be as steady state as possible to allow a more accurate measurement of the discharge energy from the battery.

## Description

### TECHNICAL FIELD

The disclosure relates generally to charging and discharging of a battery used to power an electric vehicle (EV), including battery electric vehicles (BEVs), plug-in hybrid electric vehicles (PHEVs), and hybrid electric vehicles (HEVs). In particular aspects, the disclosure relates to measuring battery capacity of a battery installed on a vehicle through a vehicle-to-grid (V2G) discharge and charge cycling operation.

The disclosure can be applied to electric heavy-duty vehicles, such as electric trucks, electric buses, and electric construction equipment, among other vehicle types. Although the disclosure may be described with respect to a particular vehicle, the disclosure is not restricted to any particular vehicle.

### BACKGROUND

Electric vehicles (EVs) have an on-board battery(ies) to provide power for vehicle operation. Battery electric vehicles (BEVs) include a battery as their sole source of power. Thus, BEVs are configured to operate exclusively on battery power at all times during their operation. On the other hand, plug-in hybrid electric vehicles (PHEVs) are only configured to operate exclusively on battery power for limited periods of time depending on battery capacity and/or or operational algorithm settings, and then operate on combustion engine power at other times. In the case of BEVs, the vehicle will no longer be able to continue operation when the battery power source no longer has a sufficient state of charge (SOC) (i.e., energy) to operate the vehicle. In both BEVs and PHEVs, a battery SOC (i.e., remaining energy capacity of the battery) can be estimated by an advanced battery SOC estimation algorithm performed by an on-board computer in the vehicle. The battery SOC can be used by the on-board computer to make decisions or suggestions on when and/or where the user should perform battery charging to re-charge the battery. The battery SOC can also be displayed to a user as a remaining drive mileage or percentage of remaining capacity, for example, so that the user can use this information to determine when battery charging may be appropriate or desired. However, older legacy electric vehicles may not be equipped with a system that estimates battery SOC. Even if an EV is equipped with a system that estimates the battery SOC, the system may be based on an older, less accurate battery SOC estimation algorithm. Also, a battery SOC estimate algorithm may become less accurate over time after a large number of charges and discharges due to the aging of the battery, known as "capacity fade." Battery aging can cause a gradual decrease in the battery's ability to store and deliver charge over time, thus causing assumptions about how charging will affect the battery SOC to be less accurate.

If an EV is not equipped with an on-board battery SOC estimation system, it may be necessary to periodically determine the exact capacity of the battery to determine if battery capacity remains sufficient for the needs or desires of the vehicle operator. Even if an EV includes an on-board battery SOC estimation system, the estimated battery SOC provided by such system may become less accurate over time due to battery aging and/or incomplete discharge/charge cycles. A full discharge/charge cycle provides more data points for accurate calibration and adjustment of the battery SOC estimation algorithm. Thus, it may still be necessary to periodically determine the exact capacity of a vehicle battery even with an on-board battery SOC estimation system. For example, a technician can be called out to the location of the vehicle to perform the full discharge and charge cycle on site at a vehicle to determine the true battery capacity of the vehicle battery. In this manner, if the true battery capacity of the vehicle battery has degraded below a desired or necessary capacity, the battery can be repaired (by replacing bad cells) or replaced. The way to truly measure the battery capacity of the vehicle battery is to fully discharge the battery followed by a full charging of the battery back to a full charge. During the charging time, the energy transferred to the battery can be measured (e.g., by integrating power transfer) to provide an accurate, current battery capacity of the battery available for energy storage and discharge. The actual battery capacity can then be reported for decisions about battery repair and/or replacement, if needed. The measured transfer energy can also be used to recalibrate settings for a battery SOC estimation algorithm for correlating charging to battery SOC.

### SUMMARY

Aspects disclosed herein involve measuring battery capacity of a battery installed on a vehicle through a vehicle-to-grid (V2G) discharge and charge cycling operation. The vehicle is an electric vehicle (EV) in that it includes an installed battery(ies) to provide a power source for operation. For example, the EV could be a battery EV (BEV) or plug-in hybrid EV (PHEV) that has the capability of recharging its battery(ies) from an external charging source (e.g., a charging station). To determine the actual battery capacity of the battery(ies), the EV can be configured to be put into a discharge/charge operational mode to perform a discharge/charge cycle to fully charge and discharge the battery. During the charging time, the energy transferred to the battery is measured (e.g., by integrating power transfer) to provide an accurate battery capacity of the battery available for energy storage and discharge. In exemplary aspects, the EV is configured to perform the discharge/charge cycle in the discharge/charge operational mode cooperatively through a power connection to a battery charging station (referred to as "charging station") that is configured to operate in a V2G mode. In this regard, the charging station is not only controllable by the EV to charge its battery from grid power, but the charging station is also controllable by the EV to discharge energy from its battery back to the grid in a V2G operation. For example, the charging station may be compatible with a V2G operational standard or specification that allows for EV batteries to be charged to store excess energy from the power grid and then be discharged back to the power grid at higher energy demand to ease pressure on the power grid infrastructure. By the EV being able to electronically request performance of the discharge/charge cycle through a connected charging station capable of charging and discharging its battery, discharging times may also be faster than can be performed by activation of on-board power-consuming devices in the EV. Also, by the EV being able to request performance of the discharge/charge cycle through a connected charging station, energy that is discharged from the EV battery can be conserved by being transferred back to the power grid.

Also, by the EV being able to electronically request performance of the discharge/charge cycle through a connected charging station capable of charging and discharging its battery, the EV can be scheduled and/or controlled, including remotely controlled, to perform the discharge/charge cycle at any time when connected to the charging station without the need for human action or intervention.

In an exemplary aspect, to perform the discharge/charge cycle for the EV battery, the EV is placed into a discharge/charge operational mode. In the discharge/charge operational mode, the EV is configured to communicate a discharge request to the charging station (e.g., over a vehicle charging port connected to the charging station) to switch the charging station to a V2G mode to fully discharge the battery to the power grid connected to the charging station in a discharge mode. The EV measures the discharge energy from the battery during discharge (e.g., by integrating power transfer to the charging station over discharging time). The measured discharge energy can be communicated and/or stored by an on-board computer (e.g., a vehicle electronic control unit (ECU)) in the EV. In one aspect, the EV disables on-board, non-essential power-consuming devices before starting the discharge cycle so that the measured discharge energy can be controlled to be as steady state (e.g., constant) as possible to allow a more accurate measurement of the discharge energy from the battery. Also, as an example, the EV may request that the charging station discharge its battery with a first higher steady state current for initial faster discharging until its battery reaches a first predetermined lower overall voltage. The first higher steady state current can achieve a balance between a faster discharge time, while at the same time not discharging energy so fast that excess energy losses are generated by the battery from discharging that can increase battery aging and degrade battery capacity. After the battery reaches the first predetermined lower overall voltage, the EV may request that the charging station continue discharging its battery with a first lower steady state current until all the battery cells of the battery are within the first predetermined lower voltage (i.e., achieve voltage equalization for a full discharge).

Then, still in the discharge/charge operational mode, the EV can communicate a charging request to the charging station (e.g., over the vehicle charging port connected to the charging station) to fully charge the battery from the power grid connected to the charging station in a charge mode. The EV may optionally wait a period of time after the discharge cycle and before communicating the charging request to the charging station to allow the energy stored in battery cells of the battery(ies) to balance. The EV requests that the connected charging station fully charge the battery from power from the power grid delivered through the charging station. The EV measures the charge energy delivered to the battery during charging (e.g., by integrating power transfer to the battery over the charging time). As an example, the EV may request that the charging station charge its battery with a second higher steady state current until its battery reaches a second predetermined higher overall voltage, and then request that the charging station charge its battery with a second lower steady state current until the battery cells reach the second predetermined higher voltage (i.e., achieve voltage equalization for a full charge). This has the advantage of providing an initial fast charging time, but as the battery SOC approaches its maximum SOC, the second lower steady state current is used to avoid excess energy resulting in heat generation through losses which can increase battery aging and degrade battery capacity.

The EV can use the measured energy transferred during the discharge and charge cycles to determine the battery capacity of its battery(ies). The measured discharge and charge energy can be stored and/or displayed to a technician or an operator of the EV. The technician or operator of the EV can use the determined battery capacity of the battery(ies) of the EV to determine if the battery(ies) should be repaired or replaced. Also, the determined battery capacity of the battery(ies) can be used by the EV to update its battery SOC estimation system and algorithm so that a more accurate SOC can be determined and/or displayed to the operator of the vehicle.

Note that the EV can also be configured in the discharge/charge operational mode to first optionally request that the connected charging station fully charge the battery from power from the power grid delivered through the charging station in an initial charge mode before the discharge mode is performed. In the initial charge mode, the EV is configured to communicate an initial charging request to the charging station (e.g., over the vehicle charging port connected to the charging station) to fully charge the battery from the power grid connected to the charging station. As an example, the EV may request that the charging station charge its battery with an initial third higher current for initial faster charging until its battery reaches a third predetermined higher overall voltage, and then request that the charging station charge its battery with a third lower current until the battery cells reach the third predetermined higher voltage (i.e., achieve voltage equalization for a full charge). This has the advantage of providing an initial faster charging time, but as the battery SOC approaches its maximum SOC, the third lower current is used to avoid excess energy resulting in heat generation through losses which can increase battery aging and degrade battery capacity.

In another exemplary aspect, the EV can be configured to initiate the discharge/charge operational mode with a connected charging station to determine the actual battery capacity of its battery(ies) based on a time-of-day (TOD) schedule, such as in the event power charges are based on TOD rates. In this manner, the EV can be configured to request performing the charging cycle(s) at times when power is less expensive and/or in lower demand, and perform the discharging cycle(s) at times when power is more expensive and/or in higher demand.

According to a first aspect of the disclosure, a computer system including processing circuitry configured to receive a request for a vehicle to enter a discharge/charge operational mode while a vehicle charging port of the vehicle is coupled to an external charging station configured to operate in a vehicle-to-grid (V2G) mode is disclosed. In response to the request for the vehicle to enter the discharge/charge operational mode, the processing circuitry is configured to deactivate power consuming devices in the vehicle not essential to the vehicle operating in the discharge/charge operational mode, communicate a discharge request to the external charging station to discharge energy from a battery in the vehicle to a power grid coupled to the external charging station at a first steady state current in a discharge mode, measure the discharged energy from the battery in the discharge mode, and detect the battery at a first predetermined lower voltage in the discharge mode. In response to detecting the battery at the first predetermined lower voltage in the discharge mode, the processing circuitry is configured to communicate a charge request to the external charging station to deliver charge energy to the battery from the power grid at a second steady state current in a charge mode, and measure the charge energy delivered to the battery in the charge mode. A technical benefit may include an EV that includes the computer system being able to electronically request performance of the discharge/charge cycle through a connected charging station capable of charging and discharging its battery, as discharging times may also be faster than can be performed by activation of on-board power-consuming devices in the EV. Also, by the EV being able to request performance of the discharge/charge cycle through a connected charging station, energy that is discharged from the EV battery can be conserved by being transferred back to the power grid.

Optionally in some examples, including in at least one preferred example, the processing circuitry is configured to communicate the discharge request by being configured to communicate a first discharge request to the external charging station to discharge energy from the battery in the vehicle to the power grid coupled to the external charging station at a first higher steady state current in the discharge mode, and detect an overall voltage of the battery at the first predetermined lower voltage in the discharge mode. In response to detecting the overall voltage of the battery at the first predetermined lower voltage in the discharge mode, the processing circuitry is further configured to communicate a second discharge request to the external charging station to discharge energy from the battery in the vehicle to the power grid at a first lower steady state current lower than the first higher steady state current in the discharge mode, and detect a voltage of cells of the battery at the first predetermined lower voltage in the discharge mode. In response to detecting the voltage of the cells of the battery at the first predetermined lower voltage in the discharge mode, the processing circuitry is further configured to communicate the charge request to the external charging station to deliver the charge energy to the battery from the power grid at the second steady state current in the charge mode, and measure the charge energy delivered to the battery in the charge mode. A technical benefit may include that using the first higher steady state current can achieve a balance between a faster discharge time, while at the same time not discharging energy so fast that excess energy losses generated by the battery from discharging can increase battery aging and degrade battery capacity. After the battery reaches the first predetermined lower overall voltage, the EV may request that the charging station continue discharging its battery with a first lower steady state current until all the battery cells of the battery are within the first predetermined lower voltage (i.e., achieve voltage equalization for a full discharge).

Optionally in some examples, including in at least one preferred example, the first predetermined lower voltage is approximately 610-620 Volts (V), the first lower steady state current is less than 5 Amps (A), and the first higher steady state current is between 5 A and 50 A. A technical benefit may include that using the first higher steady state current can achieve a balance between a faster discharge time, while at the same time not discharging energy so fast that excess energy losses generated by the battery from discharging can increase battery aging and degrade battery capacity. After the battery reaches the first predetermined lower overall voltage, the EV may request that the charging station continue discharging its battery with a first lower steady state current until all the battery cells of the battery are within the first predetermined lower voltage (i.e., achieve voltage equalization for a full discharge).

Optionally in some examples, including in at least one preferred example, the processing circuitry is further configured to, in response to detecting the battery at the first predetermined lower voltage in the discharge mode, wait for a predetermined amount of time before communicating the charge request to the external charging station. A technical benefit may include allowing the energy stored in the cells of the battery to balance when discharged.

Optionally in some examples, including in at least one preferred example, the processing circuitry is further configured to detect when the battery is at a second predetermined higher voltage in the charge mode. In response to detecting the battery is at the second predetermined higher voltage in the charge mode, the processing circuitry is further configured to disable the discharge/charge operational mode. A technical benefit may include the advantage of determining when the battery has been sufficient charged.

Optionally in some examples, including in at least one preferred example, the processing circuitry is further configured to communicate the charge request by being configured to communicate a first charge request to the external charging station to deliver the charge energy to the battery from the power grid at a second higher steady state current in the charge mode, and detect an overall voltage of the battery at the second predetermined higher voltage in the charge mode. In response to detecting the overall voltage of the battery at the second predetermined higher voltage in the charge mode, the processing circuitry is further configured to communicate a second charge request to the external charging station to deliver the charge energy to the battery from the power grid at a second lower steady state current lower than the second higher steady state current in the charge mode, and detect a voltage of cells of the battery at the second predetermined higher voltage in the charge mode. In response to detecting the voltage of the cells of the battery at the second predetermined higher voltage in the charge mode, the processing circuitry is further configured to disable the discharge/charge operational mode. A technical benefit may include the advantage of providing an initial faster charging time, but as the battery SOC approaches its maximum SOC, a lower current is used to avoid excess energy through losses resulting in heat generation, which can increase battery aging and degrade battery capacity.

Optionally in some examples, including in at least one preferred example, the second predetermined higher voltage is approximately 710-720 Volts (V), the second lower steady state current lower is less than 5 Amps (A), and the second higher steady state current lower is greater than 5 A. A technical benefit may include the advantage of providing an initial faster charging time, but as the battery SOC approaches its maximum SOC, a lower current is used to avoid excess energy through losses resulting in heat generation, which can increase battery aging and degrade battery capacity.

Optionally in some examples, including in at least one preferred example, the processing circuitry is further configured to communicate the charge request by being configured to communicate a first charge request to the external charging station to deliver the charge energy to the battery from the power grid at a second higher steady state current in the discharge mode, and detect an overall voltage of the battery at a second predetermined higher voltage in the charge mode. In response to detecting the overall voltage of the battery at the second predetermined higher voltage in the charge mode, the processing circuitry is further configured to communicate a second charge request to the external charging station to deliver the charge energy to the battery from the power grid at a second lower steady state current lower than the second higher steady state current in the charge mode, and detect a voltage of the cells of the battery at the second predetermined higher voltage in the charge mode. In response to detecting the voltage of the cells of the battery at the second predetermined higher voltage in the charge mode, the processing circuitry is further configured to disable the discharge/charge operational mode. A technical benefit may include the advantage of providing an initial faster charging time, but as the battery SOC approaches its maximum SOC, a lower current is used to avoid excess energy through losses resulting in heat generation, which can increase battery aging and degrade battery capacity.

Optionally in some examples, including in at least one preferred example, the processing circuitry is further configured to, in response to the request for the vehicle to enter the discharge/charge operational mode, prior to communicating the discharge request, communicate an initial charge request to the external charging station to deliver initial charge energy to the battery from the power grid at a third current in an initial charge mode, and detect when the battery is at a third predetermined higher voltage in the initial charge mode. In response to detecting the battery is at the third predetermined higher voltage in the initial charge mode, the processing circuitry is further configured to communicate the discharge request to the external charging station. A technical benefit may include charging the battery at a higher current to more quickly charge the battery and therefore, to more quickly perform the discharge/charge process.

Optionally in some examples, including in at least one preferred example, the processing circuitry is further configured to communicate the initial charge request by being configured to communicate a first initial charge request to the external charging station to deliver the charge energy to the battery from the power grid at a third higher current in the initial charge mode, and detect an overall voltage of the battery at the third predetermined higher voltage in the initial charge mode. In response to detecting the overall voltage of the battery at the third predetermined higher voltage in the initial charge mode, the processing circuitry is further configured to communicate a second initial charge request to the external charging station to deliver the charge energy to the battery from the power grid at a third lower current lower than the third higher current in the initial charge mode, and detect a voltage of cells of the battery at the third predetermined higher voltage in the initial charge mode. In response to detecting the voltage of the cells of the battery at the third predetermined higher voltage in the initial charge mode, the processing circuitry is further configured to communicate the discharge request to the external charging station. A technical benefit may be the advantage of providing an initial fast charging time, but as the battery SOC approaches its maximum SOC, the second lower steady state current is used to avoid excess energy through losses resulting in heat generation, which can increase battery aging and degrade battery capacity.

Optionally in some examples, including in at least one preferred example, the third predetermined higher voltage is approximately 710-720 Volts (V), the third lower current is less than 5 Amps (A), and the third higher current is between 5 A and 50A. A technical benefit may be the advantage of providing an initial fast charging time, but as the battery SOC approaches its maximum SOC, the second lower steady state current is used to avoid excess energy through losses resulting in heat generation, which can increase battery aging and degrade battery capacity.

Optionally in some examples, including in at least one preferred example, the processing circuitry is further configured to store the measured discharged energy discharged from the battery in the discharge mode, and store the measured charge energy delivered to the battery in the charge mode. A technical benefit may be to retain the measured discharged energy to be used to perform battery health analyses and/or accurately calibrate the battery SOC estimation system used to indicate battery SOC remaining for a user to make charging decisions.

Optionally in some examples, including in at least one preferred example, the processing circuitry is further configured to calibrate battery SOC estimation system based on at least one of the measured discharged energy discharged from the battery in the discharge mode, and the measured charge energy delivered to the battery in the charge mode. A technical benefit may be using the measured discharged energy to more accurately calibrate the battery SOC estimation system used to indicate battery SOC remaining for a user to make charging decisions.

Optionally in some examples, including in at least one preferred example, the processing circuitry is further configured to schedule the discharge/charge operational mode based on a time-of-day (TOD) schedule. A technical benefit may be performing the charging cycle(s) at times when power is less expensive and/or in lower demand, and performing the discharging cycle(s) at times when power is more expensive and/or in higher demand.

Optionally in some examples, including in at least one preferred example, the processing circuitry is further configured to communicate the discharge request at a first scheduled time based on a higher cost energy rate of a time-of-day (TOD) schedule, and communicate the charge request at a second scheduled time based on a lower cost energy rate of a TOD schedule, wherein the lower cost energy rate is lower than the higher cost energy rate. A technical benefit may be performing the charging cycle(s) at times when power is less expensive and/or in lower demand, and performing the discharging cycle(s) at times when power is more expensive and/or in higher demand.

Optionally in some examples, including in at least one preferred example, the processing circuitry is further configured to communicate the discharge request at a first scheduled time based on a higher energy demand of a time-of-day (TOD) schedule, and communicate the charge request at a second scheduled time based on a lower energy demand of a TOD schedule, wherein the lower energy demand is lower than the higher energy demand. A technical benefit may be performing the charging cycle(s) at times when power is in lower demand, and performing the discharging cycle(s) at times when power is in higher demand to alleviate stress on the power grid.

Optionally in some examples, including in at least one preferred example, a vehicle that includes the computer system described above is provided. A technical benefit may include the vehicle being able to electronically request performance of the discharge/charge cycle through a connected charging station capable of charging and discharging its battery, as discharging times may also be faster than can be performed by activation of on-board power-consuming devices in the EV. Also, by the EV being able to request performance of the discharge/charge cycle through a connected charging station, energy that is discharged from the EV battery can be conserved by being transferred back to the power grid.

According to a second aspect of the disclosure, a computer-implemented method including receiving, by processing circuitry of a computer system, a request for a vehicle to enter a discharge/charge operational mode while a vehicle charging port of the vehicle is coupled to an external charging station configured to operate in a vehicle-to-grid (V2G) mode is disclosed. In response to the request for the vehicle to enter the discharge/charge operational mode, the method further includes deactivating, by the processing circuitry of the computer system, power consuming devices in the vehicle not essential to the vehicle operating in the discharge/charge operational mode; communicating, by the processing circuitry of the computer system, a discharge request to the external charging station to discharge energy from a battery in the vehicle to a power grid coupled to the external charging station at a first steady state current in a discharge mode; measuring, by the processing circuitry of the computer system, the discharged energy from the battery in the discharge mode; and detecting, by the processing circuitry of the computer system, the battery at a first predetermined lower voltage in the discharge mode. In response to detecting the battery at the first predetermined lower voltage in the discharge mode, the method further includes communicating, by the processing circuitry of the computer system, a charge request to the external charging station to deliver charge energy to the battery from the power grid at a second steady state current in a charge mode; and measuring, by the processing circuitry of the computer system, the charge energy delivered to the battery in the charge mode. A technical benefit may include an EV being able to electronically request performance of the discharge/charge cycle through a connected charging station capable of charging and discharging its battery, as discharging times may also be faster than can be performed by activation of on-board power-consuming devices in the EV. Also, by the EV being able to request performance of the discharge/charge cycle through a connected charging station, energy that is discharged from the EV battery can be conserved by being transferred back to the power grid.

Optionally in some examples, including in at least one preferred example, a computer program project including program code for performing, when executed by processing circuitry, the above method discussed above is disclosed. A technical benefit may include an EV that executes the program code being able to electronically request performance of the discharge/charge cycle through a connected charging station capable of charging and discharging its battery, as discharging times may also be faster than can be performed by activation of on-board power-consuming devices in the EV. Also, by the EV being able to request performance of the discharge/charge cycle through a connected charging station, energy that is discharged from the EV battery can be conserved by being transferred back to the power grid.

Optionally in some examples, including in at least one preferred example, a non-transitory computer-readable storage medium including instructions, which when executed by processing circuitry, cause the processing circuitry to perform the method discussed above is disclosed. A technical benefit may include an EV that has transitory computer-readable storage medium including instructions to be able to electronically request performance of the discharge/charge cycle through a connected charging station capable of charging and discharging its battery, as discharging times may also be faster than can be performed by activation of on-board power-consuming devices in the EV. Also, by the EV being able to request performance of the discharge/charge cycle through a connected charging station, energy that is discharged from the EV battery can be conserved by being transferred back to the power grid.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.

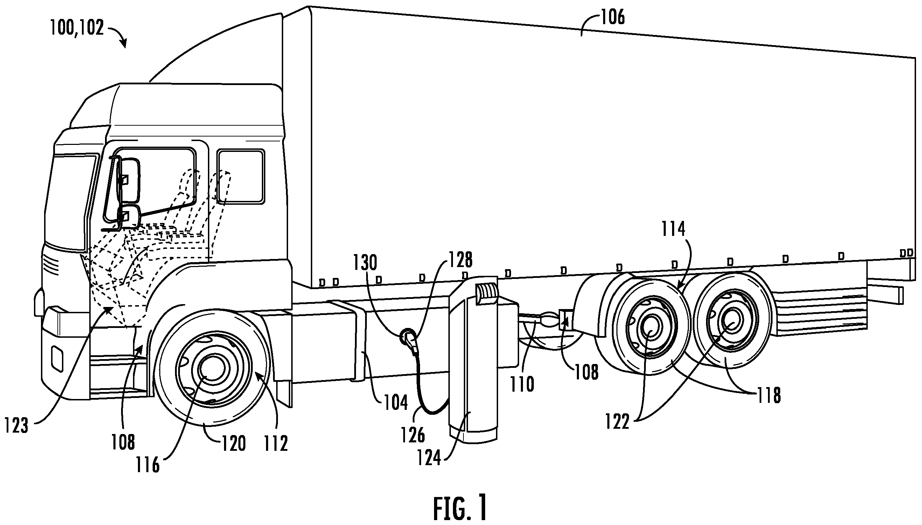

**FIG. 1** is an exemplary electric vehicle (EV) that has an on-board computer system configured to configure measure battery capacity of a battery through a vehicle-to-grid (V2G) discharge and charge cycling operation through a charging station configured to operate in a V2G mode;

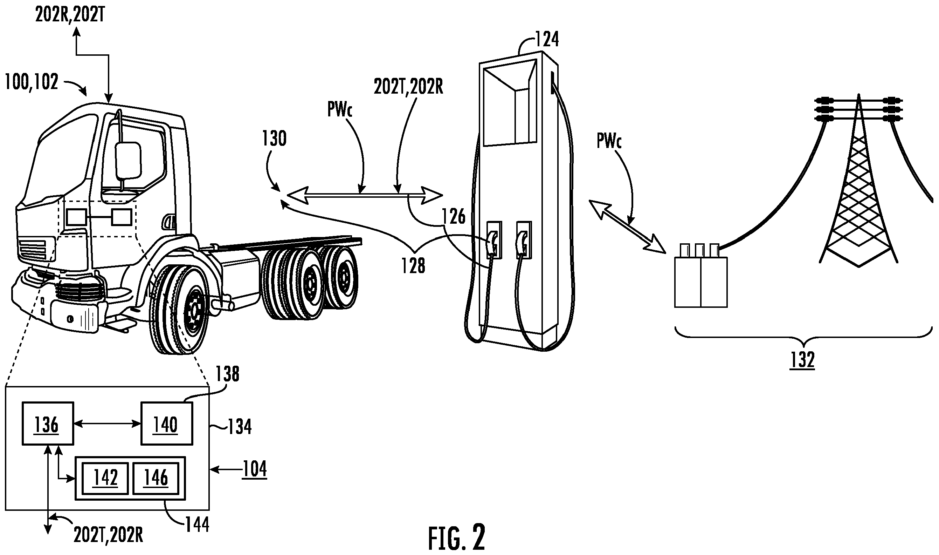

**FIG. 2** is a schematic diagram of an exemplary EV charging system that includes an exemplary EV with a computer system configured to perform a discharge/charge cycle in a discharge/charge operational mode to discharge and charge a battery in the EV through a connected charging station configured to operate in a V2G mode while measuring the discharge energy from the battery from discharging, and measuring the charge energy delivered to the battery from charging;

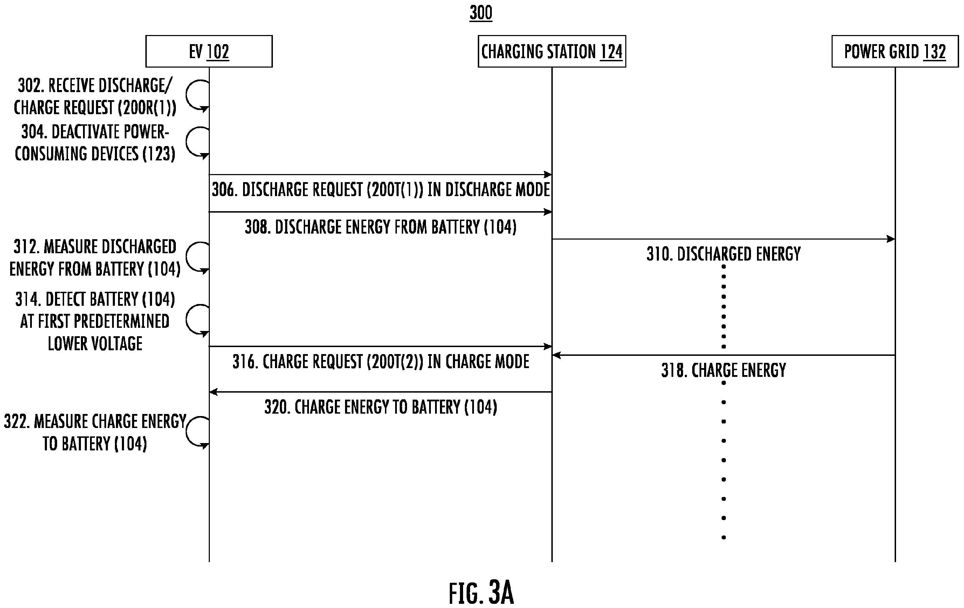

**FIG. 3A** is a flowchart illustrating an exemplary discharge/charge process of the computer system in the EV in **FIG. 2** controlling a discharge/charge cycle in a discharge/charge operational mode to discharge the battery in a discharge mode through a connected charging station operating in a V2G mode while measuring the discharge energy from the battery, and then controlling the discharge/charge cycle to charge the battery from the charging station in a charge mode while measuring the charge energy delivered to the battery;

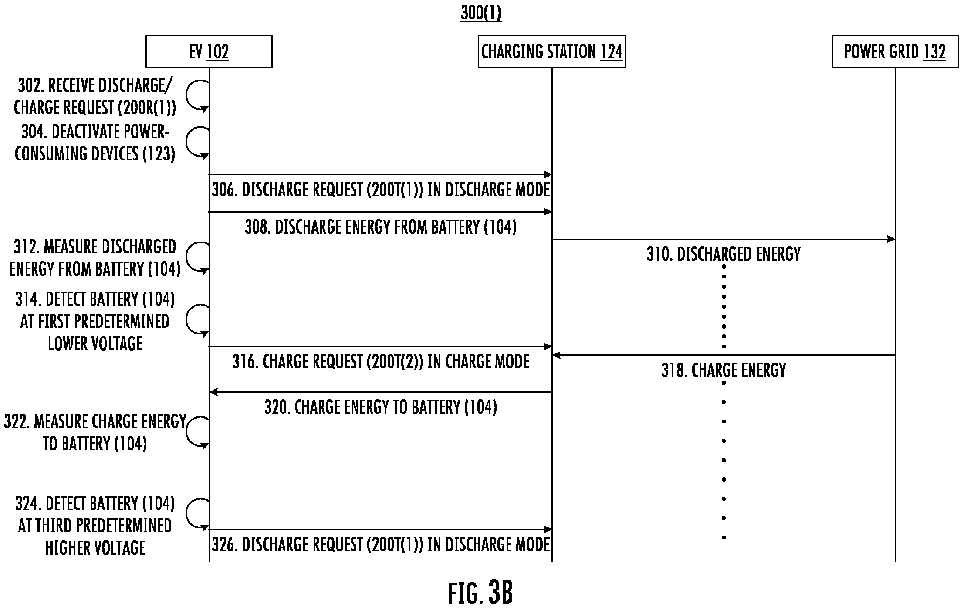

**FIG. 3B** is a flowchart illustrating another exemplary discharge/charge process of the computer system in the EV in **FIG. 2** controlling a discharge/charge cycle in a discharge/charge operational mode to discharge the battery in a discharge mode through a connected charging station operating in a V2G mode while measuring the discharge energy from the battery, and then controlling the discharge/charge cycle to charge the battery from the charging station in a charge mode while measuring the charge energy delivered to the battery;

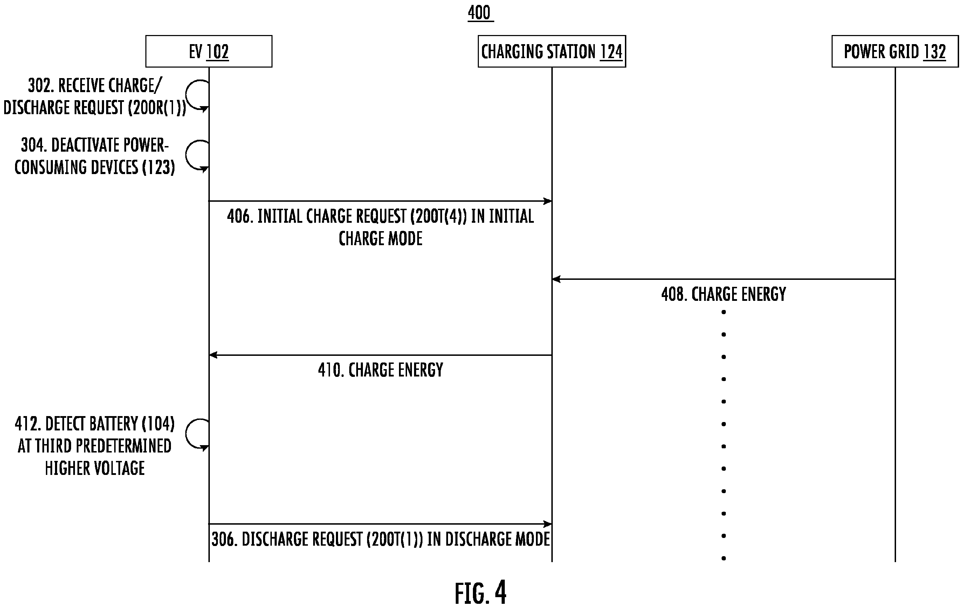

**FIG. 4** is a flowchart illustrating another exemplary discharge/charge process of the computer system in the EV in **FIGS. 1** and **2** that includes initially charging the battery from the connected charging station, and then performing the discharge/charge processes in **FIGS. 3A** or **3B****;**

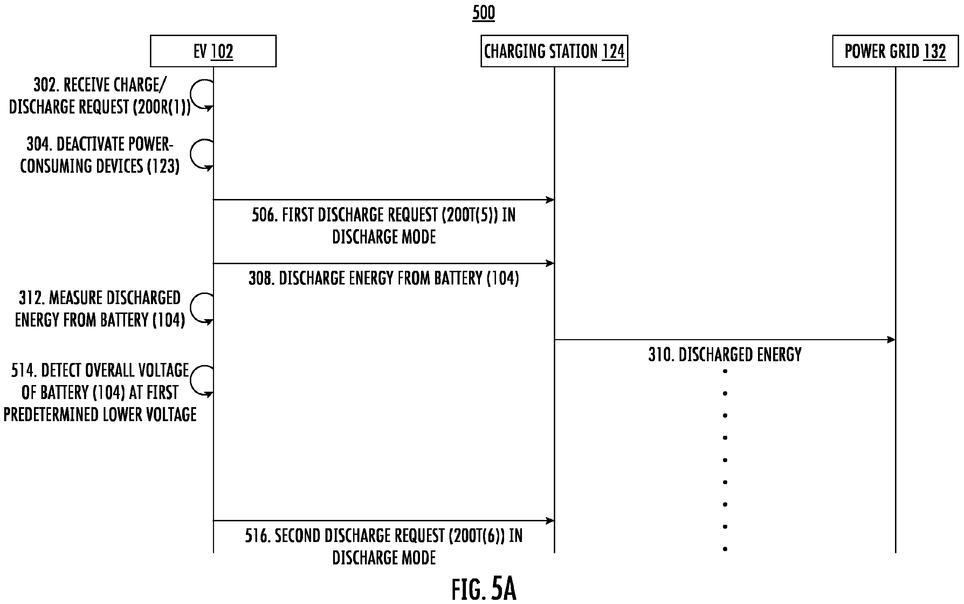

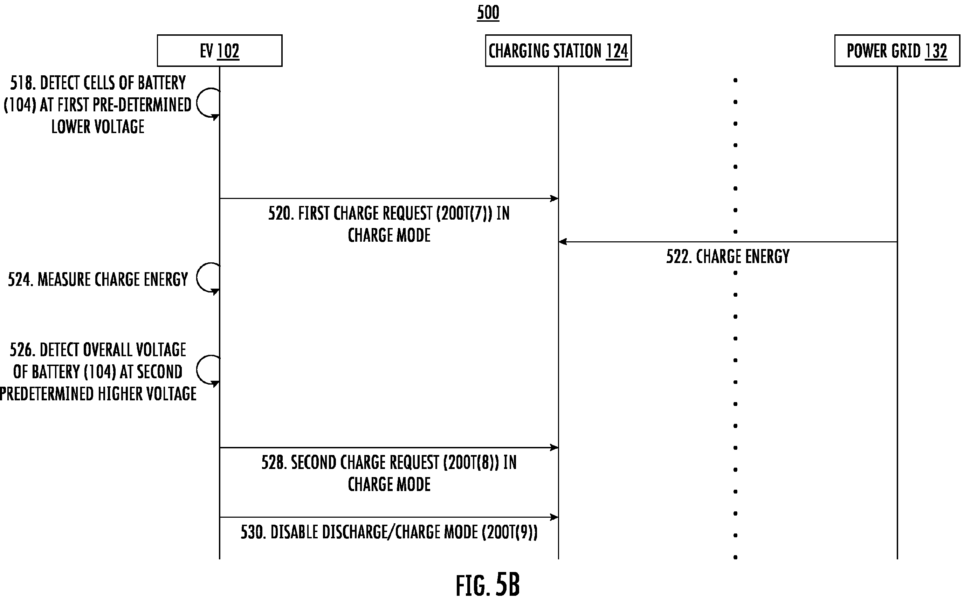

**FIGS. 5A** and **5B** is an exemplary communication flow/process illustrating an exemplary discharge/charge process of the computer system in the EV in **FIGS. 1** and **2** controlling a discharge/charge cycle in a discharge/charge operational mode to discharge the battery in a discharge mode through a connected charging station operating in a V2G mode while measuring the discharge energy from the battery, and then controlling the discharge/charge cycle to charge the battery from the charging station in a charge mode while measuring the charge energy delivered to the battery;

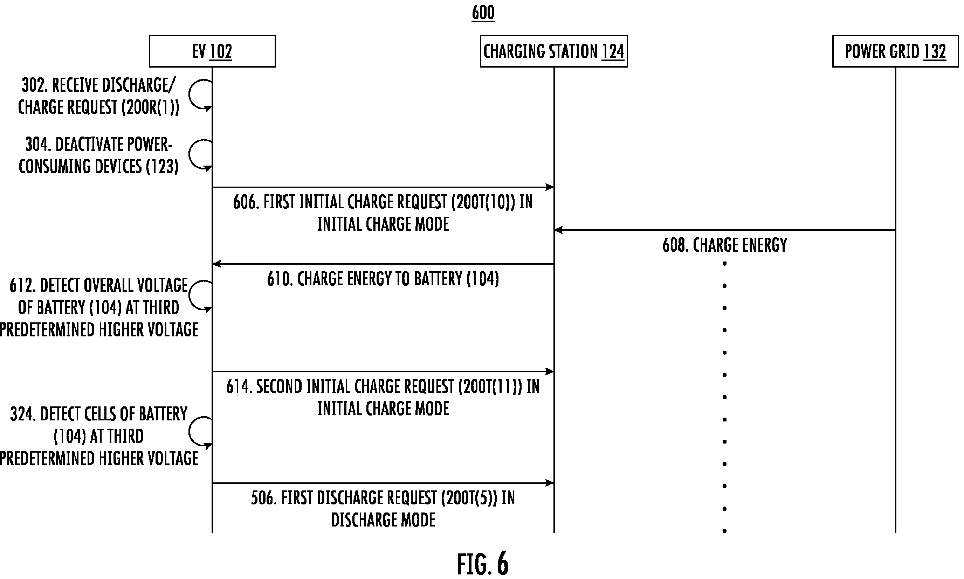

**FIG. 6** is a flowchart illustrating another exemplary discharge/charge process of the computer system in the EV in **FIGS. 1** and **2** that includes initially charging the battery from the connected charging station, and then performing the discharge/charge process in **FIGS. 5A** and **5B****;** and

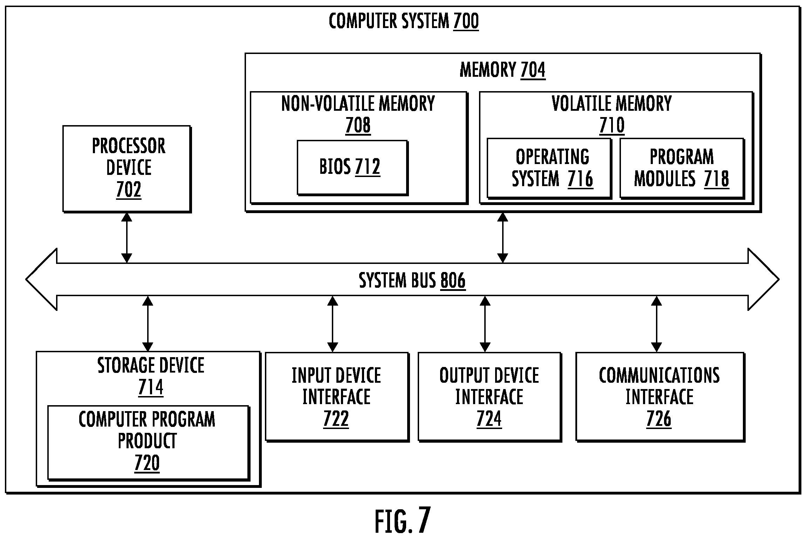

**FIG. 7** is a block diagram of an exemplary computer system that can be included in a vehicle, including, but not limited to, the computer system in **FIGS. 1** and **2****,** to perform a discharge/charge cycle in a discharge/charge operational mode to discharge and charge a battery in the EV through a connected charging station configured to operate in a V2G mode.

### DETAILED DESCRIPTION

The detailed description set forth below provides information and examples of the disclosed technology with sufficient detail to enable those skilled in the art to practice the disclosure.

Aspects disclosed herein involve measuring battery capacity of a battery installed on a vehicle through a vehicle-to-grid (V2G) discharge and charge cycling operation. The vehicle is an electric vehicle (EV) in that it includes an installed battery(ies) to provide a power source for operation. For example, the EV could be a battery EV (BEV) or plug-in hybrid EV (PHEV) that has the capability of recharging its battery(ies) from an external charging source (e.g., a charging station). To determine the actual battery capacity of the battery(ies), the EV can be configured to be put into a discharge/charge operational mode to perform a discharge/charge cycle to fully charge and discharge the battery. During the charging time, the energy transferred to the battery is measured (e.g., by integrating power transfer) to provide an accurate battery capacity of the battery available for energy storage and discharge. In exemplary aspects, the EV is configured to perform the discharge/charge cycle in the discharge/charge operational mode cooperatively through a power connection to a charging station that is configured to operate in a V2G mode. In this regard, the charging station is not only controllable by the EV to charge its battery from grid power, but the charging station is also controllable by the EV to discharge energy from its battery back to the grid in a V2G operation mode. For example, the charging station may be compatible with a V2G operational standard or specification that allows for EV batteries to be charged to store excess energy from the power grid and then be discharged back to the power grid at higher energy demand to ease pressure on the power grid infrastructure. By the EV being able to electronically request performance of the discharge/charge cycle through a connected charging station capable of charging and discharging its battery, discharging times may also be faster than can be performed by activation of on-board power-consuming devices in the EV. Also, by the EV being able to request performance of the discharge/charge cycle through a connected charging station, energy that is discharged from the EV battery can be conserved by being transferred back to the power grid.

In this regard, **FIG. 1** is an exemplary vehicle **100** that is an EV **102.** In this example, the EV **102** is a BEV that is exclusively powered by electrical energy from an on-board battery **104.** In **FIG. 1****,** the EV **102** is shown coupled to a trailer **106.** The EV **102** includes one or more electric motors **108** that are coupled to one or more respective drive shafts **110** that are the front and rear axles **112, 114.** The rotation of the drive shafts **110** will cause the power of the electric motors **108** to be transferred to the axles **112, 114** to rotate front and rear tires **116, 118** mounted on respective wheels **120, 122.** In this example, the EV **102** is also equipped to be operated in four-wheel drive (4WD), wherein separate electric motors **108** powered by the battery **104** are coupled to the respective front and rear axles **112, 114** causing the front wheels **120** and their mounted tires **116** to rotate. The EV **102** is also configured to power other power-consuming devices **123** from power in the battery **104.** For example, the other power-consuming devices **123** may include computerized displays, heating and air conditioning systems, audio equipment, and external and internal lights, as non-limiting examples.

As shown in **FIG. 1****,** the EV **102** has the on-board battery **104** that is configured to store electrical energy from recharging and release the stored electric energy to operate the electric motors **108.** **FIG. 1** shows the EV **102** being stationary and its battery **104** being charged through a coupled external charging station **124.** The charging station **124** has a charging cable **126** with a connector **128** on the end that is configured to be physically and electrically coupled to a vehicle charging port **130** on the EV **102.** As shown in **FIG. 1** and also shown in **FIG. 2****,** when the charging station **124** is placed in a charging mode, the charging station **124** draws power via a charging power signal **PWc** from a connected power grid **132** to transfer the received power through the charging cable **126** to the battery **104** to charge the battery **104.** A power grid **132** is a power delivery infrastructure that includes not only a power source for the power grid **132,** but transmission lines and transmission stations as well as last mile power lines to power equipment, such as transformers. When it is desired to no longer charge the battery **104,** the connector **128** of the charging cable **126** can be decoupled (i.e., disconnected) from the vehicle charging port **130** on the EV **102.**

As shown in **FIG. 2****,** the EV **102** has an on-board computer system **134** (e.g., an electronic control unit (ECU)) which includes processing circuitry **136,** such as a microcontroller or microprocessor. The on-board computer system **134** is powered by the battery **104.** The on-board computer system **134** is configured to measure battery capacity of the on-board battery **104** that represents a state-of-charge (SOC) of the battery **104** (also referred to as "battery SOC"). The SOC of the battery **104** is the remaining amount of energy in the battery **104** at a specific point in time available to be discharged to provide power to a coupled power-consuming device(s), such as the electric motors **108** and/or other power-consuming devices in the EV **102.** The computer system **134** may be equipped with an on-board battery SOC estimation system **138** (e.g., that includes another computer system with processing circuitry **140,** such as a microprocessor(s) and/or microcontroller(s)) that is configured to perform a battery SOC estimation algorithm (e.g., by executing computer instructions according to the battery SOC estimation algorithm) to estimate the SOC based on an estimation of power consumed during operation and driving of the EV **102.** The on-board battery SOC estimation system **138** may also be configured to provide a visual indication of the SOC of the battery **104** to a driver of the EV **102** as a percentage of stored energy as compared to the maximum storage capacity of the battery **104** and/or as an estimated travel distance (e.g., in kilometers or miles). In this manner, the driver of the vehicle can use the visual indication of the SOC of the battery **104** to determine when recharging of the battery **104** may be desired and/or for other trip planning and routing purposes. The on-board computer system **134** may also be configured to operate the EV **102** and/or provide other services based on the SOC of the battery **104** determined by the on-board battery SOC estimation system **138.** For example, the determined SOC of the battery **104** may be used by the on-board computer system **134** to control regenerative braking. For example, if the battery **104** has a higher SOC over a defined threshold, there may not be enough available storage capacity in the battery **104** to store energy generated as a result of regenerative braking. As another example, the determined SOC of the battery **104** may be used by the on-board computer system **134** for trip planning and routing to ensure that the vehicle can complete its trip on available power stored in the battery **104** and/or to suggest charging stops to the driver.

Even with the EV **102** being equipped with the computer system **134** that is capable of estimating the SOC of the battery **104,** the battery SOC estimation algorithm may become less accurate over time after a large number of charges and discharges due to the aging of the battery **104,** known as "capacity fade." The aging of the battery **104** can cause a gradual decrease in the battery's **104** ability to store and deliver charge over time, thus causing assumptions about how charging will affect the battery SOC to be less accurate. A full discharge/charge cycle of the battery **104** provides more data points for accurate calibration and adjustment of the battery SOC estimation algorithm. Thus, it may still be necessary to periodically determine the exact battery capacity of the battery **104** even with the on-board battery SOC estimation system **138.** For example, a technician can be called out to the location of the EV **102** to perform the full discharge and charge cycle on its battery **104** on site to determine the true battery capacity of the battery **104.** In this manner, if the true battery capacity of the battery **104** has degraded below a desired or necessary capacity, the battery **104** can be repaired (by replacing bad cells) or replaced. The way to truly measure battery capacity of the battery **104** is to fully discharge the battery **104** followed by a full charging of the battery **104** back to a full charge. During the charging time, the energy transferred to the battery **104** can be measured (e.g., by integrating power transfer) to provide an accurate, current battery capacity of the battery **104** available for energy storage and discharge. The actual battery capacity of the battery **104** can then be reported by the computer system **134** and/or the on-board battery SOC estimation system **138** for decisions about battery **104** repair and/or replacement, if needed. The measured transfer energy can also be used to recalibrate settings for a battery SOC estimation algorithm for correlating charging to the SOC of the battery **104.**

As discussed in more detail below, to provide for the computer system **134** and/or the on-board battery SOC estimation system **138** to determine the actual battery capacity of the battery **104,** the EV **102** can be configured to be put into a discharge/charge operational mode to perform a discharge/charge cycle to fully charge and discharge the battery **104.** The computer system **134** and/or its processing circuitry **136** can be configured to set an operational mode indicator **142** (e.g., a memory register) in a memory **144** in the computer system **134** when the EV **102** is put into a discharge/charge operational mode. For example, the operational mode indicator **142** could be a memory word that includes either that the EV **102** is in a non-charge mode (e.g. '0x00' bits), the EV **102** is in a discharge mode (e.g. 'Ox01' bits), the EV **102** is in a charge mode (e.g. '0x10' bits), or the EV **102** is in an initial charge mode (e.g. '0x11' bits), which are discussed in more detail below. This is so that the computer system **134** and/or its processing circuitry **136** can track the operational mode during operations performed in the discharge/charge cycle of the EV **102** as discussed in more detail below. The computer system **134** and/or its processing circuitry **136** can also be configured to store a measured amount of energy discharged and/or charged from the battery **104** in an energy measurement indicator **146** in the memory **144** for access by the computer system **134** and/or its processing circuitry **136** or the on-board battery SOC estimation system **138.**

During the charging time in a charge mode, the energy transferred to the battery **104** is measured (e.g., by integrating power transfer) to provide an accurate battery capacity of the battery **104** available for energy storage and discharge. In exemplary aspects, the EV **102** (or its computer system **134** and/or the on-board battery SOC estimation system **138**) is configured to perform the discharge/charge cycle for the battery **104** in the discharge/charge operational mode cooperatively through the power connection to the charging station **124** that is configured to operate in a V2G mode. In this example, the charging station **124** is compatible with the V2G operation that allows energy to be transferred back (i.e., pushed back) to its connected power grid **132** from the battery **104** of the EV **102.** For example, when it is stated that energy is transferred back to the power grid **132,** it is understood that the discharge energy from the battery **104** transferred by the charging station **124** to the power grid **132** may be delivered to a next closest power consuming facility to the charging station **124** also coupled to the power grid **132** based on the principle of energy flowing to the path of least resistance. In this manner, the charging station **124** can be used in a discharge mode while connected to the EV **102** to provide a discharge path for discharging energy stored in the battery **104** without such discharge energy having to be lost through consumption by activated on-board power-consuming devices in the EV **102** and/or in the form of heat dissipation from energy losses. The charging station **124** compatible with V2G operation also allows for EV batteries, such as the battery **104** of the EV **102,** to be charged to store excess energy from the power grid **132** at times of lower energy demand and then be discharged back to the power grid **132** during times of higher energy demand to ease pressure on the power infrastructure of the power grid **132.**

Thus, in this example, the charging station **124** is not only controllable by the EV **102** to charge its battery **104** from the power grid **132** connected to the charging station **124,** but the charging station **124** is also controllable by the EV **102** to discharge energy from its battery **104** back to the power grid **132** in a V2G operation mode. By the EV **102** being able to electronically request performance of the discharge/charge cycle through the connected charging station **124** capable of charging and discharging its battery **104,** discharging times may also be faster than can be performed by activation of on-board power-consuming devices in the EV **102.** Also, by the EV **102** being able to request performance of the discharge/charge cycle through the connected charging station **124,** energy that is discharged from the battery **104** of the EV **102** can be conserved by being transferred back to the power grid **132** via the charging station **124** being configured for V2G charging/discharging.

**FIG. 3A** is a flowchart illustrating an exemplary discharge/charge process **300** of the computer system **134** and/or the on-board battery SOC estimation system **138** in the EV **102** in **FIGS. 1** and **2** controlling a discharge/charge cycle in a discharge/charge operational mode. The discharge/charge process **300** in **FIG. 3A** is discussed with reference to the exemplary EV **102** and charging station **124** in **FIG. 2****.** As discussed in more detail below, the computer system **134** and/or its processing circuitry **136** in the EV **102** is configured to discharge the battery in a discharge mode through the connected charging station **124** operating in a V2G mode while measuring the discharge energy from the battery **104,** and then causing the battery **104** to be charged in a charge mode while measuring the charge energy delivered from the charging station **124** to the battery **104.** The EV **102** can use the measured energy transferred during the discharge and charge cycles to determine the battery capacity of its battery **104.**

In this regard, as shown in **FIG. 3A****,** the discharge/charge process **300** includes the computer system **134** and/or its processing circuitry **136** receiving a discharge/charge request **200R(1)** for the EV **102** to enter a discharge/charge operational mode while the vehicle charging port **130** of the EV **102** is coupled to the charging station **124** configured to operate in a V2G mode (block **302** in **FIG. 3A**). For example, the EV **102** may have a user interface that can communicate the discharge/charge request **200R(1)** to the computer system **134** and/or its processing circuitry **136** in response to a technician requesting the EV **102** be placed in a discharge/charge operational mode to perform a discharge/charge process **300** in order to determine the battery capacity of the battery **104.** Alternatively, the EV **102** may be configured to receive a remote communication, such as over the charging cable **126** as a received communication signal **200R** as shown in **FIG. 2** or through a received wireless telemetry signal **202R,** to receive the discharge/charge request **200R(1)** to cause the computer system **134** to perform the discharge/charge process **300.** This may be advantageous if it is desired to avoid the need for a technician to have to be dispatched to the location of the EV **102** to request the EV **102**/computer system **134** to perform the to perform the discharge/charge process **300.**

Then, with continuing reference to **FIG. 3A****,** in response to the request for the EV **102** to enter the discharge/charge operational mode to perform the discharge/charge process **300** in step **302,** the computer system **134** and/or its processing circuitry **136** is configured to deactivate (e.g., turn off, idle) power-consuming devices **123** in the EV **102** that are not essential to the EV **102** operating in the discharge/charge operational mode (block **304** in **FIG. 3A**). This is so that other power-consuming devices **123** that are not essential to the EV **102** operating in the discharge/charge operational mode in the discharge/charge process **300** do not consume power from the battery **104.** Otherwise, it may not be possible to obtain an accurate capacity of the battery **104** in the EV **102** since, as discussed below, the rate of discharge and charge of the battery **104** and the power discharged and consumed from discharging and charging is used to determine the capacity of the battery **104.**

Then, with continuing reference to **FIG. 3A****,** after the power-consuming devices **123** in the EV **102** that are not essential to the EV **102** operating in the discharge/charge operational mode are de-activated (block **304** in **FIG. 3A**), the computer system **134** and/or its processing circuitry **136** is then configured to communicate a discharge request **200T(1)** in a discharge mode to the charging station **124** to discharge energy from the battery **104** in the EV **102** to the power grid **132** coupled to the charging station **124** (block **306** in **FIG. 3A**). The computer system **134** and/or its processing circuitry **136** may be configured to store a discharge mode in the operational mode indicator **142** in response to receiving the discharge request **200T(1).** In this example, to determine the capacity of the battery **104,** the battery **104** is discharged so that when the battery **104** is subsequently charged, the battery **104** is charged from a known SOC to allow a more accurate determination of the capacity of the battery **104.** The discharge request **200T(1)** can be part of a transmission signal **200T** communicated from the EV **102** over the charging cable **126** to the charging station **124** as shown in **FIG. 2** as an example. In response to the charging station **124** receiving the discharge request **200T(1)** in the discharge mode, the charging station **124** is configured to discharge energy from the battery **104** of the EV **102** through the charging cable **126** (block **308** in **FIG. 3A** and also see **FIG. 2**). The discharged energy from the battery **104** that is transferred to and received by the charging station **124** can be transferred to the power grid **132** (block **310** in **FIG. 3A**). In an example, in the discharge mode, the EV **102** may be configured to communicate the discharge request **200T(1)** to the charging station **124** to instruct the charging station **124** to discharge energy from the battery **104** of the EV **102** at a first steady state current (e.g., between 5 Amps (A) and 50 A). In this manner, it may be possible for the computer system **134** and/or its processing circuitry **136** to more accurately measure the discharged energy from the battery **104.**

Then, with continuing reference to **FIG. 3A****,** in the discharge mode as the energy from the battery **104** is discharged by the charging station **124** (block **308** in **FIG. 3A**), the computer system **134** and/or its processing circuitry **136** is configured to measure the discharged energy from the battery **104** (block **312** in **FIG. 3A**)**.** For example, the computer system **134** and/or its processing circuitry **136** can be configured to measure the discharged energy from the battery **104** by integrating the instantaneous discharged energy from the battery **104** to the charging station **124.** The computer system **134** and/or its processing circuitry **136** may be configured to store the measured discharged energy from the battery **104** in the discharge mode in the EV **102.** The computer system **134** and/or its processing circuitry **136** continues in the discharge mode until the battery **104** is detected to be at a first predetermined lower voltage (e.g., less than 610-620 Volts (V) in an 800 V charging system) indicative of the battery **104** being fully discharged or sufficiently discharged before beginning a charge cycle (block **314** in **FIG. 3A**).

In response to detecting the battery **104** at the first predetermined lower voltage in the discharge mode (block **314** in **FIG. 3A**), the computer system **134** and/or its processing circuitry **136** is then configured to communicate a charge request **200T(2)** to the charging station **124** in a charge mode (block **316** in **FIG. 3A**). The computer system **134** and/or its processing circuitry **136** may be configured to store a charge mode in the operational mode indicator **142** in response to receiving the charge request **200T(2).** The computer system **134** and/or its processing circuitry **136** may be configured to wait for a predetermined amount of time before communicating the charge request **200T(2)** to the charging station **124** after detecting the battery **104** to be at the first predetermined lower voltage in the discharge mode (block **314** in **FIG. 3A**) to allow the energy stored in cells of the battery **104** to balance. The charge request **200T(2)** can be part of a transmission signal **200T** communicated from the EV **102** over the charging cable **126** to the charging station **124** as shown in **FIG. 2** as an example. This causes the charging station **124** to transfer energy received from the power grid **132** (block **318** in **FIG. 3A****)** to the battery **104** over the charging cable **126** (block **320** in **FIG. 3A**) to charge the battery **104.** In an example, in the charge mode, the EV **102** may be configured to communicate the charge request **200T(2)** to the charging station **124** to instruct the charging station **124** to deliver charge energy to the battery **104** of the EV **102** at a second steady state current (e.g., between 5 A and 50 A). In this manner, it may be possible for the computer system **134** and/or its processing circuitry **136** to more accurately measure the charge energy delivered to the battery **104.**

In the charge mode, as the received charge energy charges the battery **104,** the computer system **134** and/or its processing circuitry **136** is configured to measure the charge energy delivered to the battery **104** (block **322** in **FIG. 3A**). For example, the computer system **134** and/or its processing circuitry **136** can be configured to measure the charged energy delivered to the battery **104** by integrating the instantaneous charge delivered to the battery **104** from the charging station **124.** The computer system **134** and/or its processing circuitry **136** may be configured to store the measured charge energy delivered to the battery **104** in the charge mode in the EV **102** in the energy measurement indicator **146** in the memory **144.**

**FIG. 3B** is a flowchart illustrating another exemplary discharge/charge process 300(1) of the computer system **134** and/or the on-board battery SOC estimation system **138** in the EV **102** in **FIGS. 1** and **2** controlling a discharge/charge cycle in a discharge/charge operational mode. The discharge/charge process **300(1)** in **FIG. 3B** is discussed with reference to the exemplary EV **102** and charging station **124** in **FIG. 2****.** The discharge/charge process **300(1)** in **FIG. 3B** includes the same steps **302-322** as in the discharge/charge process **300** in **FIG. 3A****.**

In the discharge/charge process **300(1)** in **FIG. 3B****,** the computer system **134** and/or its processing circuitry **136** continues in the charge mode (e.g., as indicated in the operational mode indicator **142)** until the battery **104** is detected to be at a second predetermined higher voltage (e.g., 710-720 V in an 800 V charging system) indicative of the battery **104** being fully charged or sufficiently charged (block **324** in **FIG. 3B**). The battery **104** being at the second predetermined higher voltage is an indication of the battery **104** being fully charged or sufficiently charged such that the measured charge energy is an indication of the capacity of the battery **104.** In response to detecting the battery **104** at the second predetermined higher voltage (block **324** in **FIG. 3B**), the computer system **134** and/or its processing circuitry **136** is configured to disable the discharge/charge mode by communicating a discharge/charge mode request **200T(3)** to the charging station **124** to discontinue charging (block **326** in **FIG. 3B**).

In any of the aforementioned processes or otherwise in another discharge/charge process, the EV **102** and/or its computer system **134** or its processing circuitry **136,** or the on-board battery SOC estimation system **138** can use the measured energy (e.g., stored in the energy measurement indicator **146** in the memory **144**) transferred during the discharge and charge cycles with the battery **104** in either the discharge/charge processes **300, 300(1)** in **FIGS. 3A** and **3B** to determine the battery capacity of the battery **104.** The measured discharge and charge energy can be displayed to a technician or an operator of the EV **102.** The technician or operator of the EV can use the determined battery capacity of the battery **104** of the EV **102** to determine if the battery **104** should be repaired or replaced. Also, the determined battery capacity of the battery **104** can be used by the EV **102** to update the battery SOC estimation system **138** and algorithm so that a more accurate SOC can be determined and/or displayed to the operator of the EV **102.**

Also, by the EV **102** being able to electronically request performance of the discharge/charge cycle through a connected battery charging station **124** capable of charging and discharging its battery **104,** the EV **102** can be scheduled and/or controlled, including remotely controlled, to perform the discharge/charge process **300** at any time when connected to the charging station **124** without the need for human action or intervention. In another exemplary aspect, the EV **102** can be configured to initiate the discharge/charge operational mode with the connected charging station **124** to determine the battery capacity of its battery **104** based on a certain scheduled time in a time-of-day (TOD) schedule that has information on varying power rates based on TOD which may be based on energy demand on the power grid **132.** For example, when TOD power rates are higher and/or energy demand on the power grid **132** is higher, the EV **102** can be configured to perform a discharge cycle of the battery **104** in the discharge mode to transfer energy back to the power grid **132.** This provides more energy on the power grid **132** to help supply higher energy demand and/or may entitle the EV **102** to a higher power transfer credit when energy rates are higher. In the converse, the EV **102** can also be configured to perform a charge cycle of the battery **104** in the charge mode to receive transferred energy from the power grid **132** to charge the battery **104** when TOD power rates are lower and/or energy demand on the power grid **132** is reduced. This causes energy to be transferred from the power grid **132** when energy demand is lower and when energy rates are less expensive.

Note that the EV **102** can also be configured in the discharge/charge operational mode to first optionally request that the connected charging station **124** charge the battery **104** from power from the power grid **132** delivered through the charging station **124** in an initial charge mode before a discharge mode is performed. This is shown in the exemplary alternative discharge/charge process **400** for the EV **102** in **FIG. 4** that includes initially charging the battery **104** from the connected charging station **124,** before performing the discharge/charge processes **300 or 300(1)** in **FIGS. 3A** and **3B****.**

The discharge/charge process **400** in **FIG. 4** is discussed with reference to the exemplary EV **102** and charging station **124** in **FIG. 2****.** As discussed in more detail below, the computer system **134** and/or the on-board battery SOC estimation system **138** in the EV **102** is configured to discharge the battery **104** in a discharge mode through the connected charging station **124** operating in a V2G mode while measuring the discharge energy from the battery **104,** and then cause the battery **104** to be charged in a charge mode while measuring the charge energy delivered from the charging station **124** to the battery **104.** The EV **102** can use the measured energy transferred during the discharge and charge cycles to determine the battery capacity of its battery **104.**

In this regard, as shown in **FIG. 4****,** the alternative discharge/charge process **400** includes the computer system **134** and/or its processing circuitry **136** receiving a discharge/charge request **200R(1)** for the EV **102** to enter a discharge/charge operational mode while the vehicle charging port **130** of the EV **102** is coupled to the charging station **124** configured to operate in a V2G mode (block **302** in **FIG. 4**). Then, in response to the request for the EV **102** to enter the discharge/charge operational mode to perform the discharge/charge process **400** in step **302,** the computer system **134** and/or its processing circuitry **136** deactivates (e.g., turn off, idle) power-consuming devices **123** in the EV **102** that are not essential to the EV **102** operating in the discharge/charge operational mode (block **304** in **FIG. 4**). This has been previously described in the discharge/charge processes **300** or **300(1)** in **FIGS. 3A** and **3B****.**

With continuing reference to **FIG. 4****,** instead of communicating the discharge request **200T(1)** to the charging station **124** as discussed in block **306** in the discharge/charge processes **300, 300(1)** in **FIGS. 3A** and **3B****,** the computer system **134** and/or its processing circuitry **136** instead communicates an optional initial charge request **200T(4)** to the charging station **124** in an initial charge mode (block **406** in **FIG. 4**). The computer system **134** and/or its processing circuitry **136** may be configured to store an initial charge mode in the operational mode indicator **142** in response to receiving the discharge request **200T(4).** The initial charge request **200T(4)** can be part of a transmission signal **200T** communicated from the EV **102** over the charging cable **126** to the charging station **124** as shown in **FIG. 2** as an example. This causes the charging station **124** to transfer energy received from the power grid **132** (block **408** in **FIG. 4****)** to the battery **104** over the charging cable **126** (block **410** in **FIG. 4**) to initially charge the battery **104.** In an example, in the initial charge mode, the EV **102** communicates the initial charge request **200T(4)** to the charging station **124** to instruct the charging station **124** to deliver charge energy to the battery **104** of the EV **102** at a third current (e.g., which may be a steady state and may also be between 5 A and 50 A).

The computer system **134** and/or its processing circuitry **136** continues in the initial charge mode until the battery **104** is detected to be at a third predetermined higher voltage (e.g., 710-720 V in an 800 V nominal voltage charging system) indicative of the battery **104** being fully charged or sufficiently charged (block **412** in **FIG. 4**). In response to detecting the battery **104** at the third predetermined higher voltage (block **412** in **FIG. 4**)**,** the computer system **134** and/or its processing circuitry **136** enters into the discharge mode by communicating the discharge request **200T(1)** to the charging station **124** to discharge the battery **104** as shown in block **306** in **FIGS. 3A** and **3B****.** The computer system **134** and/or its processing circuitry **136** may be configured to store a discharge mode in the operational mode indicator **142** in response to receiving the discharge request **200T(1).** The remainder of this alternative discharge/charge process **400** can be performed starting at block **306** in **FIGS. 3A** and **3B** and continuing to block **326** in the discharge/charge process **300(1)** in **FIG. 3B** **just** as described above.

**FIGS. 5A** and **5B** are a flowchart illustrating another exemplary discharge/charge process **500** of the computer system **134** and/or the on-board battery SOC estimation system **138** in the EV **102** in **FIGS. 1** and **2** controlling a discharge/charge cycle in a discharge/charge operational mode. As discussed in more detail below, the discharge/charge process **500** in **FIGS. 5A** and **5B** is similar to the discharge/charge processes **300, 300(1)** in **FIGS. 3A** and **3B****,** however, the discharge/charge process **500** involves using multiple current levels in both the discharging and charging of the battery **104** to achieve faster discharging and charging times, while avoiding excesses energy losses and battery **104** degradation when the battery **104** is near a full charge. The discharge/charge process **500** in **FIGS. 5A** and **5B** is discussed with reference to the exemplary EV **102** and charging station **124** in **FIG.** 2. Like the discharge/charge processes **300, 300(1)** in **FIGS. 3A** and **3B****,** the discharge/charge process **500** in **FIGS. 5A** and **5B** involves the computer system **134** and/or its processing circuitry **136** in the EV **102** discharging the battery **104** in a discharge mode through the connected charging station **124** operating in a V2G mode while measuring the discharge energy from the battery **104,** and then causing the battery **104** to be charged in a charge mode while measuring the charge energy delivered from the charging station **124** to the battery **104.** The EV **102** can use the measured energy transferred during the discharge and charge cycles to determine the battery capacity of its battery **104.**

In this regard, as shown in **FIG. 5A****,** the discharge/charge process **500** includes the computer system **134** and/or its processing circuitry **136** receiving the discharge/charge request **200R(1)** for the EV **102** to enter a discharge/charge operational mode while the vehicle charging port **130** of the EV **102** is coupled to the charging station **124** configured to operate in a V2G mode like in **FIGS. 3A** and **3B** (block **302** in **FIG. 5A**). Common steps between the discharge/charge process **500** in **FIG. 5A** and the discharge/charge processes **300, 300(1)** in **FIGS. 3A** and **3B** are shown with common block numbers. Then, in response to the request for the EV **102** to enter the discharge/charge operational mode to perform the discharge/charge process **500** in step **302,** the computer system **134** and/or its processing circuitry **136** deactivates (e.g., turn off, idle) power-consuming devices **123** in the EV **102** that are not essential to the EV **102** operating in the discharge/charge operational mode like in **FIGS. 3A** and **3B** (block **304** in **FIG. 5A**).

Then, with continuing reference to **FIG. 5A****,** after the power-consuming devices **123** in the EV **102** that are not essential to the EV **102** operating in the discharge/charge operational mode are de-activated (block **304** in **FIG. 5A**), the computer system **134** and/or its processing circuitry **136** communicates a first discharge request **200T(5)** in a discharge mode to the charging station **124** to discharge energy from the battery **104** in the EV **102** to the power grid **132** coupled to the charging station **124** (block **506** in **FIG. 5A**)**.** The computer system **134** and/or its processing circuitry **136** may be configured to store the discharge mode in the operational mode indicator **142** in response to receiving the first discharge request **200T(5).** The first discharge request **200T(5)** requests that the charging station **124** discharge the battery **104** at a first higher steady state current (e.g., 5 A to 50 A) in this example. In this manner, the discharging of the battery **104** can be performed at a faster discharge rate to reduce the overall duration of the discharge/charge process **500.** In response to the charging station **124** receiving the first discharge request **200T(5)** in the discharge mode, the charging station **124** discharges energy from the battery **104** of the EV **102** through the charging cable **126** (block **308** in **FIG. 5A**). The discharged energy from the battery **104** that is transferred to and received by the charging station **124** can be transferred to the power grid **132** (block **310** in **FIG. 5A**). In an example, in the discharge mode, the EV **102** communicates the first discharge request **200T(5)** to the charging station **124** to instruct the charging station **124** to discharge energy from the battery **104** of the EV **102** at the first higher steady state current, as a steady state current. In this manner, it may be possible for the computer system **134** and/or its processing circuitry **136** to more accurately measure the discharged energy from the battery **104.**

Then, with continuing reference to **FIG. 5A****,** in the discharge mode as the energy from the battery **104** is discharged by the charging station **124** (block **308** in **FIG. 5A**), the computer system **134** and/or its processing circuitry **136** measures the discharged energy from the battery **104** (block **312** in **FIG. 5A**). For example, the computer system **134** and/or its processing circuitry **136** can be configured to measure the discharged energy from the battery **104** by integrating the instantaneous discharged energy from the battery **104** to the charging station **124.** The computer system **134** and/or its processing circuitry **136** may be configured to store the measured discharged energy from the battery **104** (e.g., in the energy measurement indicator **146** in the memory **144**) in the discharge mode in the EV **102.** The computer system **134** and/or its processing circuitry **136** continues in the discharge mode until the overall voltage of the battery **104** is detected to be at the first predetermined lower voltage (e.g., less than 610-620 V) indicative of the battery **104** being fully discharged or sufficiently discharged before beginning a charge cycle (block **514** in **FIG. 5A**).

In response detecting the overall voltage of the battery **104** is at the first predetermined lower voltage in the discharge mode (block **514** in **FIG. 5A**), the computer system **134** and/or its processing circuitry **136** communicates a second discharge request **200T(6)** to the charging station **124** in the discharge mode (block **516** in **FIG. 5A**) to discharge the battery **104** at a first lower steady state current (e.g., < 5A) lower than the first higher steady state current (block **516** in **FIG. 5A**). The computer system **134** and/or its processing circuitry **136** continues to measure the discharged energy from the battery **104** (block **312** in **FIG. 5A**). Discharging the battery **104** at the first higher steady state current can achieve a balance between a faster discharge time, while at the same time not discharging energy so fast that excess energy losses are generated by the battery **104** from discharging that can increase battery aging and degrade battery capacity. After the overall voltage of the battery **104** reaches the first predetermined lower voltage, the computer system **134** and/or its processing circuitry **136** requests that the charging station **124** continue discharging the battery **104** at the first lower steady state current until all the battery cells of the battery **104** are within the first predetermined lower voltage (i.e., achieve voltage equalization for a full discharge) (e.g., 3.26 V = 620 V / 190 battery cells).

Then, as shown in **FIG. 5B****,** the computer system **134** and/or its processing circuitry **136** detects when the cells of the battery **104** are at the first predetermined lower voltage in the discharge mode (i.e., achieve voltage equalization for a full charge) (block **518** in **FIG. 5B**). This has the advantage of providing an initial fast charging time, but as the SOC of the battery **104** approaches its maximum SOC, the second lower steady state current is used to avoid excess energy resulting in heat generation through losses which can increase battery **104** aging and degrade battery capacity. In response detecting the cells of the battery **104** at the first predetermined lower voltage in the discharge mode (block **518** in **FIG. 5B**), the computer system **134** and/or its processing circuitry **136** communicates a first charge request **200T(7)** to the charging station **124** in a charge mode to charge the battery **104** at a second higher steady state current (e.g., SA to 50 A) higher than the first steady state current (block **520** in **FIG. 5B**). The computer system **134** and/or its processing circuitry **136** may be configured to store the charge mode in the operational mode indicator **142** in response to receiving the first charge request **200T(7).** In the charge mode charge energy is delivered to the battery **104** for charging (block **522** in **FIG. 5B**) from the power grid **132.** The computer system **134** and/or its processing circuitry **136** measures the charge energy from the battery **104** (block **524** in **FIG. 5B**). For example, the computer system **134** and/or its processing circuitry **136** can be configured to measure the charge energy from the battery **104** by integrating the instantaneous charge energy delivered to the battery **104** from the charging station **124.** The computer system **134** and/or its processing circuitry **136** may also be configured to wait for a predetermined amount of time before communicating the first charge request **200T(7)** to the charging station **124** after detecting the cells of the battery **104** are at the first predetermined lower voltage in the discharge mode (block **518** in **FIG. 5B**) to allow the energy stored in the cells of the battery **104** to balance.

The computer system **134** and/or its processing circuitry **136** may request that the charging station **124** to charge the battery **104** initially with a second higher steady state current until its battery **104** until the battery cells of the battery **104** achieve voltage equalization for a full charge. This has the advantage of providing an initial fast charging time, but as the SOC of the battery **104** approaches its maximum SOC, a second lower steady state current can be requested for charging to avoid excess energy resulting in heat generation through losses which can increase battery **104** aging and degrade battery capacity.

In this regard, as shown in **FIG. 5B****,** the computer system **134** and/or its processing circuitry **136** then detects when the overall voltage of the battery **104** is at a second predetermined higher voltage (e.g., 710-720 V) in the charge mode (block **526** in **FIG. 5B**). This is an indication of overall voltage equalization in the battery **104.** In response to detect when the overall voltage of the battery **104** is at a second predetermined higher voltage, the computer system **134** and/or its processing circuitry **136** then communicates a second charge requests **200T(8)** to the charging station **124** to request delivering of charge energy to charge the batter 104 at a second lower steady state current (e.g., < 5 A) lower than the second higher steady state current for the first charge request **200T(7)** (block **528** in **FIG. 5B**)**.** The computer system **134** and/or its processing circuitry **136** continues to measure the charge energy delivered to the battery **104** (block **524** in **FIG. 5B**)**.** The computer system **134** and/or its processing circuitry **136** detects when the voltage of the cells of the battery **104** are at the second predetermined higher voltage (e.g., 3.78 V = 720 V / 190 battery cells) in the charge mode (block **526** in **FIG. 5B**)**.** This is an indication that all the cells of the battery **104** have been fully charged or are charged to the desired voltage. In response to detecting the voltage of the cells of the battery **104** are at the second predetermined higher voltage in the charge mode, the computer system **134** and/or its processing circuitry **136** disables the discharge/charge mode by communicating a discharge/charge mode request **200T(9)** to the charging station **124** to discontinue charging (block **530** in **FIG. 5B**)**.** The computer system **134** and/or its processing circuitry **136** may be configured to store the non-charge mode in the operational mode indicator **142** in response to receiving the first discharge request **200T(9).**

Note that as discussed above, the EV **102** and/or its computer system **134** or its processing circuitry **136,** or the on-board battery SOC estimation system **138** can use the measured energy transferred during the discharge and charge cycles with the battery **104** as part of the discharge/charge process **500** in **FIGS. 5A** and **5B** to determine the battery capacity of the battery **104.** The measured discharge and charge energy (e.g., stored in the energy measurement indicator **146** in the memory **144**) can be displayed to a technician or an operator of the EV **102.** The technician or operator of the EV can use the determined battery capacity of the battery **104** of the EV **102** to determine if the battery **104** should be repaired or replaced. Also, the determined battery capacity of the battery **104** can be used by the EV **102** to update the battery SOC estimation system **138** and algorithm so that a more accurate SOC can be determined and/or displayed to the operator of the EV **102.** The TOD considerations discussed above with regard to the discharge/charge processes **300, 300(1)** in **FIGS. 3A** and **3B** can also be used in the discharge/charge process **500** in **FIGS. 5A** and **5B****.**

**FIG. 6** is an alternative discharge/charge process **600** that includes the computer system **134** and/or its processing circuitry **136** performing an optional initial charge of the battery **104** to then perform the discharge/charge process **500** in **FIGS. 5A** and **5B****.** As shown in **FIG. 6****,** the computer system **134** and/or its processing circuitry **136** receives the discharge/charge request **200R(1)** for the EV **102** to enter the discharge/charge operational mode while the vehicle charging port **130** of the EV **102** is coupled to the charging station **124** configured to operate in a V2G mode (block **302** in **FIG. 6****)**. Then, in response to the request for the EV **102** to enter a discharge/charge operational mode to perform the discharge/charge process **600** in step **302,** the computer system **134** and/or its processing circuitry **136** deactivates (e.g., turns off, idles) power-consuming devices **123** in the EV **102** that are not essential to the EV **102** operating in the discharge/charge operational mode (block **304** in **FIG. 6**). This has been previously described in the discharge/charge processes **300, 300(1)** in **FIGS. 3A** and **3B****.**

With continuing reference to **FIG. 6****,** instead of communicating the first discharge request **200T(5)** to the charging station **124** as discussed in block **506** in the discharge/charge process **500** in **FIG. 5A****,** the computer system **134** and/or its processing circuitry **136** communicates a first initial charge request **200T(10)** to the charging station **124** in an initial charge mode (block **606** in **FIG. 4**)**.** The computer system **134** and/or its processing circuitry **136** may be configured to store the initial charge mode in the operational mode indicator **142** in response to receiving the first initial charge request **200T(10).** The first initial charge request **200T(10)** can be part of a transmission signal **200T** communicated from the EV **102** over the charging cable **126** to the charging station **124** as shown in **FIG. 2** as an example. This causes the charging station **124** to transfer energy received from the power grid **132** (block **608** in **FIG. 6**) to the battery **104** over the charging cable **126** (block **610** in **FIG. 6**) to initially charge the battery **104.** In an example, in the initial charge mode, the EV **102** communicates the first initial charge request **200T(10)** to the charging station **124** to instruct the charging station **124** to deliver charge energy to the battery **104** of the EV **102** at a third higher current (e.g. 5 A to 50 A) in the initial charge mode so that charging will occur faster.

In the initial charge mode charge energy is delivered to the battery **104** for charging (block **608** in **FIG. 6**) from the power grid **132** and through the charging station **124** (block **610** in **FIG. 6**)**.** The computer system **134** and/or its processing circuitry **136** detects when an overall voltage of the battery **104** reaches a third predetermined higher voltage (e.g., 710-720 V in an 800V charging system) indicating that the battery **104** is almost fully charged (block **612** in **FIG. 6**)**.** In response to detecting the overall voltage of the battery **104** reaching the third predetermined higher voltage indicating that the battery **104** is almost fully charged (block **612** in **FIG. 6**), the computer system **134** and/or its processing circuitry **136** communicates a second initial charge request **200T(11)** to the charging station **124** to charge the battery **104** at a third lower current (e.g., < 5 A) lower than the third higher current in the initial charge mode (block **614** in **FIG. 6**)**.** This is so that excess heat is not generated from charging the battery **104** leading to losses and battery **104** degradation. The computer system **134** and/or its processing circuitry **136** then detects when the cells of the battery **104** reach the third predetermined higher voltage signifying voltage equalization in the cells of the battery **104** indicating a full charge (block **616** in **FIG. 6**)**.** In response to detecting when the cells of the battery **104** reach the third predetermined higher voltage (e.g., (e.g., 3.78 V = 720 V / 190 battery cells) signifying voltage equalization in the cells of the battery **104** indicating a full charge (block **616** in **FIG. 6**), the computer system **134** and/or its processing circuitry **136** enters into the discharge mode by communicating the first discharge request **200T(5)** to the charging station **124** to discharge the battery **104** shown in block **506** in **FIG. 6**)**.** The computer system **134** and/or its processing circuitry **136** may be configured to store the discharge mode in the operational mode indicator **142** in response to receiving the first discharge request **200T(5).** The remainder of this alternative discharge/charge process **600** can be performed starting at block **506** in **FIG. 5A** and continuing to block **530** in **FIG. 5B** just as described above.

**FIG. 7** is a block diagram of a computer system **700** for implementing any examples disclosed herein. For example, the computer system **134,** its processing circuitry **136,** and the on-board battery SOC estimation system **138,** could each be provided by the computer system **700** in **FIG. 7****.** The computer system **700** is adapted to execute instructions from a computer-readable medium to perform these and/or any of the functions or processing described herein. The computer system **700** may be connected (e.g., networked) to other machines in a local area network (LAN), an intranet, an extranet, or the Internet. While only a single device is illustrated, the computer system **700** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or j ointly execute a set (or multiple sets) of instructions to perform any one or more of the methodologies discussed herein. For example, a control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **700** may comprise at least one computing device or electronic device capable of including firmware, hardware, and/or executing software instructions to implement the functionality described herein. The computer system **700** may include processing circuitry **702** (e.g., a processor including one or more processor devices or control units), a memory **704,** and a system bus **706.** The processing circuitry **702** could be the processing circuitry **136** in **FIG. 2****,** as an example. The computer system **700** may include at least one computing device having the processing circuitry **702.** The system bus **706** provides an interface for system components including, but not limited to, the memory **704** and the processing circuitry **702.** The memory **704** could be used to store the measured discharged energy and/or charge energy discharged and/or used to charge the battery **104** of the EV **102.** The memory **704** also stores the algorithm used by the on-board battery SOC estimation system **138** to estimate the SOC of the battery **104.** The processing circuitry **702** may include any number of hardware components for conducting data or signal processing or for executing computer code stored in the memory **704.** The processing circuitry **702** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **702** may further include computer executable code that controls operation of the programmable device.

The system bus **706** may be any of several types of bus structures that may further interconnect to a memory bus (with or without a memory controller), a peripheral bus, and/or a local bus using any of a variety of bus architectures. The memory **704** may be one or more devices for storing data and/or computer code for completing or facilitating methods described herein. The memory **704** may include database components, object code components, script components, or other types of information structure for supporting the various activities herein. Any distributed or local memory device may be utilized with the systems and methods of this description. The memory **704** may be communicably connected to the processing circuitry **702** (e.g., via a circuit or any other wired, wireless, or network connection) and may include computer code for executing one or more processes described herein. The memory **704** may include non-volatile memory **708** (e.g., read-only memory (ROM), erasable programmable read-only memory (EPROM), electrically erasable programmable read-only memory (EEPROM), etc.), and volatile memory **710** (e.g., random-access memory (RAM)), or any other medium which can be used to carry or store desired program code in the form of machine-executable instructions or data structures and which can be accessed by a computer or other machine with processing circuitry **702.** A basic input/output system (BIOS) **712** may be stored in the non-volatile memory **708** and can include the basic routines that help to transfer information between elements within the computer system **700.**

The computer system **700** may further include or be coupled to a non-transitory computer-readable storage medium such as a storage device **714,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **714** and other drives associated with computer-readable media and computer-usable media may provide non-volatile storage of data, data structures, computer-executable instructions, and the like.

Computer code which is hard or soft coded may be provided in the form of one or more modules. The module(s) can be implemented as software and/or hard-coded in circuitry to implement the functionality described herein in whole or in part. The modules may be stored in the storage device **714** and/or in the volatile memory **710,** which may include an operating system **716** and/or one or more program modules **718.** All or a portion of the examples disclosed herein may be implemented as a computer program **720** stored on a transitory or non-transitory computer-usable or computer-readable storage medium (e.g., single medium or multiple media), such as the storage device **714,** which includes complex programming instructions (e.g., complex computer-readable program code) to cause the processing circuitry **702** to carry out actions described herein. Thus, the computer-readable program code of the computer program **720** can comprise software instructions for implementing the functionality of the examples described herein when executed by the processing circuitry **702.** In some examples, the storage device **714** may be a computer program product (e.g., readable storage medium) storing the computer program **720** thereon, where at least a portion of the computer program **720** may be loadable (e.g., into a processor or processing circuitry) for implementing the functionality of the examples described herein when executed by the processing circuitry **702.** The processing circuitry **702** may serve as a controller or control system for the computer system **700** that is to implement the functionality described herein.

The computer system **700** may include an input device interface **722** configured to receive input and selections to be communicated to the computer system **700** when executing instructions, such as from a keyboard, mouse, touch-sensitive surface, etc. Such input devices may be connected to the processing circuitry **702** through the input device interface **722** coupled to the system bus **706** but can be connected through other interfaces, such as a parallel port, an Institute of Electrical and Electronic Engineers (IEEE) 1394 serial port, a Universal Serial Bus (USB) port, an IR interface, and the like. The computer system **700** may include an output device interface **724** configured to forward output, such as to a display, a video display unit (e.g., a liquid crystal display (LCD) or a cathode ray tube (CRT)). The computer system **700** may include a communications interface **726** suitable for communicating with a network as appropriate or desired.

The operational actions described in any of the exemplary aspects herein are described to provide examples and discussion. The actions may be performed by hardware components, may be embodied in machine-executable instructions to cause a processor or processing circuitry to perform the actions, or may be performed by a combination of hardware and software. Although a specific order of method actions may be shown or described, the order of the actions may differ. In addition, two or more actions may be performed concurrently or with partial concurrence.

Implementation examples are described in the following numbered clauses:
Example 1: A computer system comprising processing circuitry configured to:
   receive a request for a vehicle to enter a discharge/charge operational mode while a vehicle charging port of the vehicle is coupled to an external charging station configured to operate in a vehicle-to-grid (V2G) mode; and
   in response to the request for the vehicle to enter the discharge/charge operational mode:
   deactivate power consuming devices in the vehicle not essential to the vehicle operating in the discharge/charge operational mode;
   communicate a discharge request to the external charging station to discharge energy from a battery in the vehicle to a power grid coupled to the external charging station at a first steady state current in a discharge mode;
   measure the discharged energy from the battery in the discharge mode;
   detect the battery at a first predetermined lower voltage in the discharge mode; and
   in response to detecting the battery at the first predetermined lower voltage in the discharge mode:
      communicate a charge request to the external charging station to deliver charge energy to the battery from the power grid at a second steady state current in a charge mode; and
   measure the charge energy delivered to the battery in the charge mode.
Example 2: The computer system of Example 1, wherein the processing circuitry is configured to communicate the discharge request by being configured to:
   communicate a first discharge request to the external charging station to discharge energy from the battery in the vehicle to the power grid coupled to the external charging station at a first higher steady state current in the discharge mode;
   detect an overall voltage of the battery at the first predetermined lower voltage in the discharge mode; and
   in response to detecting the overall voltage of the battery at the first predetermined lower voltage in the discharge mode:
      communicate a second discharge request to the external charging station to discharge energy from the battery in the vehicle to the power grid at a first lower steady state current lower than the first higher steady state current in the discharge mode;
      detect a voltage of cells of the battery at the first predetermined lower voltage in the discharge mode; and
      in response to detecting the voltage of the cells of the battery at the first predetermined lower voltage in the discharge mode: communicate the charge request to the external charging station to deliver the charge energy to the battery from the power grid at the second steady state current in the charge mode; and
      measure the charge energy delivered to the battery in the charge mode.
Example 3: The computer system of Example 2, wherein:
   the first predetermined lower voltage is approximately 610-620 Volts (V);
   the first lower steady state current is less than 5 Amps (A); and
   the first higher steady state current is between 5 A and 50 A.
Example 4: The computer system of Example 1, wherein the processing circuitry is further configured to, in response to detecting the battery at the first predetermined lower voltage in the discharge mode, wait for a predetermined amount of time before communicating the charge request to the external charging station.
Example 5: The computer system of any of Examples 1-4, wherein the processing circuitry is configured to:
   detect when the battery is at a second predetermined higher voltage in the charge mode; and
   in response to detecting the battery is at the second predetermined higher voltage in the charge mode:
      disable the discharge/charge operational mode.
Example 6: The computer system of Example 5, wherein the processing circuitry is configured to communicate the charge request by being configured to:
   communicate a first charge request to the external charging station to deliver the charge energy to the battery from the power grid at a second higher steady state current in the charge mode;
   detect an overall voltage of the battery at the second predetermined higher voltage in the charge mode; and
   in response to detecting the overall voltage of the battery at the second predetermined higher voltage in the charge mode:
      communicate a second charge request to the external charging station to deliver the charge energy to the battery from the power grid at a second lower steady state current lower than the second higher steady state current in the charge mode;
      detect a voltage of cells of the battery at the second predetermined higher voltage in the charge mode; and
      in response to detecting the voltage of the cells of the battery at the second predetermined higher voltage in the charge mode:
      disable the discharge/charge operational mode.
Example 7: The computer system of Example 6, wherein:
   the second predetermined higher voltage is approximately 710-720 Volts (V);
   the second lower steady state current lower is less than 5 Amps (A); and
   the second higher steady state current lower is greater than 5 A.
Example 8: The computer system of Example 2, wherein the processing circuitry is configured to communicate the charge request by being configured to:
   communicate a first charge request to the external charging station to deliver the charge energy to the battery from the power grid at a second higher steady state current in the discharge mode;
   detect an overall voltage of the battery at a second predetermined higher voltage in the charge mode; and
   in response to detecting the overall voltage of the battery at the second predetermined higher voltage in the charge mode:
      communicate a second charge request to the external charging station to deliver the charge energy to the battery from the power grid at a second lower steady state current lower than the second higher steady state current in the charge mode;
      detect a voltage of the cells of the battery at the second predetermined higher voltage in the charge mode; and
      in response to detecting the voltage of the cells of the battery at the second predetermined higher voltage in the charge mode: disable the discharge/charge operational mode.
Example 9: The computer system of any of Examples 5-7, wherein the processing circuitry is further configured to, in response to the request for the vehicle to enter the discharge/charge operational mode, prior to communicating the discharge request:
   communicate an initial charge request to the external charging station to deliver initial charge energy to the battery from the power grid at a third current in an initial charge mode; and
   detect when the battery is at a third predetermined higher voltage in the initial charge mode; and
   in response to detecting the battery is at the third predetermined higher voltage in the initial charge mode: communicate the discharge request to the external charging station.
Example 10: The computer system of Example 9, wherein the processing circuitry is configured to communicate the initial charge request by being configured to:
   communicate a first initial charge request to the external charging station to deliver the charge energy to the battery from the power grid at a third higher current in the initial charge mode;
   detect an overall voltage of the battery at the third predetermined higher voltage in the initial charge mode; and
   in response to detecting the overall voltage of the battery at the third predetermined higher voltage in the initial charge mode:
      communicate a second initial charge request to the external charging station to deliver the charge energy to the battery from the power grid at a third lower current lower than the third higher current in the initial charge mode;
      detect a voltage of cells of the battery at the third predetermined higher voltage in the initial charge mode; and
      in response to detecting the voltage of the cells of the battery at the third predetermined higher voltage in the initial charge mode:
         communicate the discharge request to the external charging station.
Example 11: The computer system of Example 10, wherein:
   the third predetermined higher voltage is approximately 710-720 Volts (V);
   the third lower current is less than 5 Amps (A); and
   the third higher current is between 5 A and 50A.
Example 12: The computer system of any of Examples 1-11, wherein the processing circuitry is further configured to:
   store the measured discharged energy discharged from the battery in the discharge mode; and
   store the measured charge energy delivered to the battery in the charge mode.
Example 13: The computer system of Example 12, wherein the processing circuitry is further configured to calibrate battery state-of-charge (SOC) estimation system based on at least one of the measured discharged energy discharged from the battery in the discharge mode, and the measured charge energy delivered to the battery in the charge mode.
Example 14: The computer system of any of Examples 1-13, wherein the processing circuitry is further configured to schedule the discharge/charge operational mode based on a time-of-day (TOD) schedule.
Example 15: The computer system of any of Examples 1-13, wherein the processing circuitry is further configured to:
   communicate the discharge request at a first scheduled time based on a higher cost energy rate of a time-of-day (TOD) schedule; and
   communicate the charge request at a second scheduled time based on a lower cost energy rate of a TOD schedule, wherein the lower cost energy rate is lower than the higher cost energy rate.
Example 16: The computer system of any of Examples 1-13, wherein the processing circuitry is further configured to:
   communicate the discharge request at a first scheduled time based on a higher energy demand of a time-of-day (TOD) schedule; and
   communicate the charge request at a second scheduled time based on a lower energy demand of a TOD schedule, wherein the lower energy demand is lower than the higher energy demand.
Example 17: A vehicle comprising the computer system of any of Examples 1-16.
Example 18: A computer-implemented method, comprising:
   receiving, by processing circuitry of a computer system, a request for a vehicle to enter a discharge/charge operational mode while a vehicle charging port of the vehicle is coupled to an external charging station configured to operate in a vehicle-to-grid (V2G) mode; and
   in response to the request for the vehicle to enter the discharge/charge operational mode:
      deactivating, by the processing circuitry of the computer system, power consuming devices in the vehicle not essential to the vehicle operating in the discharge/charge operational mode;
      communicating, by the processing circuitry of the computer system, a discharge request to the external charging station to discharge energy from a battery in the vehicle to a power grid coupled to the external charging station at a first steady state current in a discharge mode;
      measuring, by the processing circuitry of the computer system, the discharged energy from the battery in the discharge mode;
      detecting, by the processing circuitry of the computer system, the battery at a first predetermined lower voltage in the discharge mode; and
      in response to detecting the battery at the first predetermined lower voltage in the discharge mode:
         communicating, by the processing circuitry of the computer system, a charge request to the external charging station to deliver charge energy to the battery from the power grid at a second steady state current in a charge mode; and
         measuring, by the processing circuitry of the computer system, the charge energy delivered to the battery in the charge mode.
Example 19: A computer program product comprising program code for performing, when executed by processing circuitry, the method of Example 18.
Example 20: A non-transitory computer-readable storage medium comprising instructions, which when executed by processing circuitry, cause the processing circuitry to perform the method of Example 18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system comprising processing circuitry configured to:
receive a request for a vehicle to enter a discharge/charge operational mode while a vehicle charging port of the vehicle is coupled to an external charging station configured to operate in a vehicle-to-grid (V2G) mode; and
in response to the request for the vehicle to enter the discharge/charge operational mode:
deactivate power consuming devices in the vehicle not essential to the vehicle operating in the discharge/charge operational mode;
communicate a discharge request to the external charging station to discharge energy from a battery in the vehicle to a power grid coupled to the external charging station at a first steady state current in a discharge mode;
measure the discharged energy from the battery in the discharge mode;
detect the battery at a first predetermined lower voltage in the discharge mode; and
in response to detecting the battery at the first predetermined lower voltage in the discharge mode:
communicate a charge request to the external charging station to deliver charge energy to the battery from the power grid at a second steady state current in a charge mode; and
measure the charge energy delivered to the battery in the charge mode.

2. The computer system of claim 1, wherein the processing circuitry is configured to communicate the discharge request by being configured to:
communicate a first discharge request to the external charging station to discharge energy from the battery in the vehicle to the power grid coupled to the external charging station at a first higher steady state current in the discharge mode;
detect an overall voltage of the battery at the first predetermined lower voltage in the discharge mode; and
in response to detecting the overall voltage of the battery at the first predetermined lower voltage in the discharge mode:
communicate a second discharge request to the external charging station to discharge energy from the battery in the vehicle to the power grid at a first lower steady state current lower than the first higher steady state current in the discharge mode;
detect a voltage of cells of the battery at the first predetermined lower voltage in the discharge mode; and
in response to detecting the voltage of the cells of the battery at the first predetermined lower voltage in the discharge mode:
communicate the charge request to the external charging station to deliver the charge energy to the battery from the power grid at the second steady state current in the charge mode; and
measure the charge energy delivered to the battery in the charge mode.

3. The computer system of claim 2, wherein:
the first predetermined lower voltage is approximately 610-620 Volts (V);
the first lower steady state current is less than 5 Amps (A); and
the first higher steady state current is between 5 A and 50 A.

4. The computer system of any of claims 1-3, wherein the processing circuitry is configured to:
detect when the battery is at a second predetermined higher voltage in the charge mode; and
in response to detecting the battery is at the second predetermined higher voltage in the charge mode:
disable the discharge/charge operational mode.

5. The computer system of claim 4, wherein the processing circuitry is configured to communicate the charge request by being configured to:
communicate a first charge request to the external charging station to deliver the charge energy to the battery from the power grid at a second higher steady state current in the charge mode;
detect an overall voltage of the battery at the second predetermined higher voltage in the charge mode; and
in response to detecting the overall voltage of the battery at the second predetermined higher voltage in the charge mode:
communicate a second charge request to the external charging station to deliver the charge energy to the battery from the power grid at a second lower steady state current lower than the second higher steady state current in the charge mode;
detect a voltage of cells of the battery at the second predetermined higher voltage in the charge mode; and
in response to detecting the voltage of the cells of the battery at the second predetermined higher voltage in the charge mode:
disable the discharge/charge operational mode.

6. The computer system of claim 2, wherein the processing circuitry is configured to communicate the charge request by being configured to:
communicate a first charge request to the external charging station to deliver the charge energy to the battery from the power grid at a second higher steady state current in the discharge mode;
detect an overall voltage of the battery at a second predetermined higher voltage in the charge mode; and
in response to detecting the overall voltage of the battery at the second predetermined higher voltage in the charge mode:
communicate a second charge request to the external charging station to deliver the charge energy to the battery from the power grid at a second lower steady state current lower than the second higher steady state current in the charge mode;
detect a voltage of the cells of the battery at the second predetermined higher voltage in the charge mode; and
in response to detecting the voltage of the cells of the battery at the second predetermined higher voltage in the charge mode:
disable the discharge/charge operational mode.

7. The computer system of any of claim 4-5, wherein the processing circuitry is further configured to, in response to the request for the vehicle to enter the discharge/charge operational mode, prior to communicating the discharge request:
communicate an initial charge request to the external charging station to deliver initial charge energy to the battery from the power grid at a third current in an initial charge mode; and
detect when the battery is at a third predetermined higher voltage in the initial charge mode; and
in response to detecting the battery is at the third predetermined higher voltage in the initial charge mode:
communicate the discharge request to the external charging station.

8. The computer system of claim 7, wherein the processing circuitry is configured to communicate the initial charge request by being configured to:
communicate a first initial charge request to the external charging station to deliver the charge energy to the battery from the power grid at a third higher current in the initial charge mode;
detect an overall voltage of the battery at the third predetermined higher voltage in the initial charge mode; and
in response to detecting the overall voltage of the battery at the third predetermined higher voltage in the initial charge mode:
communicate a second initial charge request to the external charging station to deliver the charge energy to the battery from the power grid at a third lower current lower than the third higher current in the initial charge mode;
detect a voltage of cells of the battery at the third predetermined higher voltage in the initial charge mode; and
in response to detecting the voltage of the cells of the battery at the third predetermined higher voltage in the initial charge mode:
communicate the discharge request to the external charging station.

9. The computer system of any of claims 1-8, wherein the processing circuitry is further configured to:
store the measured discharged energy discharged from the battery in the discharge mode;
store the measured charge energy delivered to the battery in the charge mode; and
calibrate battery state-of-charge (SOC) estimation system based on at least one of the measured discharged energy discharged from the battery in the discharge mode, and the measured charge energy delivered to the battery in the charge mode.

10. The computer system of any of claims 1-9, wherein the processing circuitry is further configured to:
communicate the discharge request at a first scheduled time based on a higher cost energy rate of a time-of-day (TOD) schedule; and
communicate the charge request at a second scheduled time based on a lower cost energy rate of a TOD schedule, wherein the lower cost energy rate is lower than the higher cost energy rate.

11. The computer system of any of claims 1-9, wherein the processing circuitry is further configured to:
communicate the discharge request at a first scheduled time based on a higher energy demand of a time-of-day (TOD) schedule; and
communicate the charge request at a second scheduled time based on a lower energy demand of a TOD schedule, wherein the lower energy demand is lower than the higher energy demand.

12. A vehicle comprising the computer system of any of claims 1-11.

13. A computer-implemented method, comprising:
receiving, by processing circuitry of a computer system, a request for a vehicle to enter a discharge/charge operational mode while a vehicle charging port of the vehicle is coupled to an external charging station configured to operate in a vehicle-to-grid (V2G) mode; and
in response to the request for the vehicle to enter the discharge/charge operational mode:
deactivating, by the processing circuitry of the computer system, power consuming devices in the vehicle not essential to the vehicle operating in the discharge/charge operational mode;
communicating, by the processing circuitry of the computer system, a discharge request to the external charging station to discharge energy from a battery in the vehicle to a power grid coupled to the external charging station at a first steady state current in a discharge mode;
measuring, by the processing circuitry of the computer system, the discharged energy from the battery in the discharge mode;
detecting, by the processing circuitry of the computer system, the battery at a first predetermined lower voltage in the discharge mode; and
in response to detecting the battery at the first predetermined lower voltage in the discharge mode:
communicating, by the processing circuitry of the computer system, a charge request to the external charging station to deliver charge energy to the battery from the power grid at a second steady state current in a charge mode; and
measuring, by the processing circuitry of the computer system, the charge energy delivered to the battery in the charge mode.

14. A computer program product comprising program code for performing, when executed by processing circuitry, the method of claim 13.

15. A non-transitory computer-readable storage medium comprising instructions, which when executed by processing circuitry, cause the processing circuitry to perform the method of claim 13.
